# EUROPEAN PATENT APPLICATION

(11) **EP 2 581 182 A1**
(43) Date of publication of application: **17.04.2013**
(21) Application number: 11792551.1
(22) Date of filing: 10.06.2011
(51) Int. Cl.: B26D 1/18, H01L 31/042

(54) **MODULE TRIMMING METHOD AND TRIMMING APPARATUS**

(30) Priority: 17.06.2010 JP 2010138625; 11.06.2010 JP 2010133912
(71) Applicant: Sharp Kabushiki Kaisha, Osaka-shi, Osaka 545-8522 (JP)
(72) Inventor: IYATANI, Kazushi, Osaka-shi, Osaka 545-8522 (JP)
(74) Representative: Müller - Hoffmann & Partner
(86) International application number: PCT/JP2011/063330
(87) International publication number: WO 2011/155594

(57) **Abstract**

A rotating blade having a blade edge that has a sloped surface to become gradually narrower in a blade thickness direction outward along a radial direction is inclined about an axis along a thickness direction of the substrate toward a substrate at a cutting angle, and an excess portion of a module is cut off by relatively moving at least one of the rotating blade and the module in a cutting direction along an end face of the substrate while the rotating blade is being rotated in one direction.

## Description

### Technical Field

The present invention relates to trimming methods and devices for removing an excess portion of a sealing member in a module (e.g., a solar module etc.) in which a substrate is sealed by the sealing member.

### Background Art

In recent years, growing importance has been attached to action on environmental protection, and there has been a demand for resource and energy conservation. In order to achieve energy conservation, for example, techniques of generating power that has no environmental load with use of solar modules or the like have been carried out at many places. Under these circumstances, stable production of modules (e.g., a solar module etc.) has been desired.

Modules (e.g., a solar module etc.) typically have a structure that a substrate of transparent glass or the like on which a semiconductor cell (e.g., a solar cell etc.) is mounted is covered by a sealing member (e.g., ethylene-vinyl acetate (EVA), a back sheet, etc.).

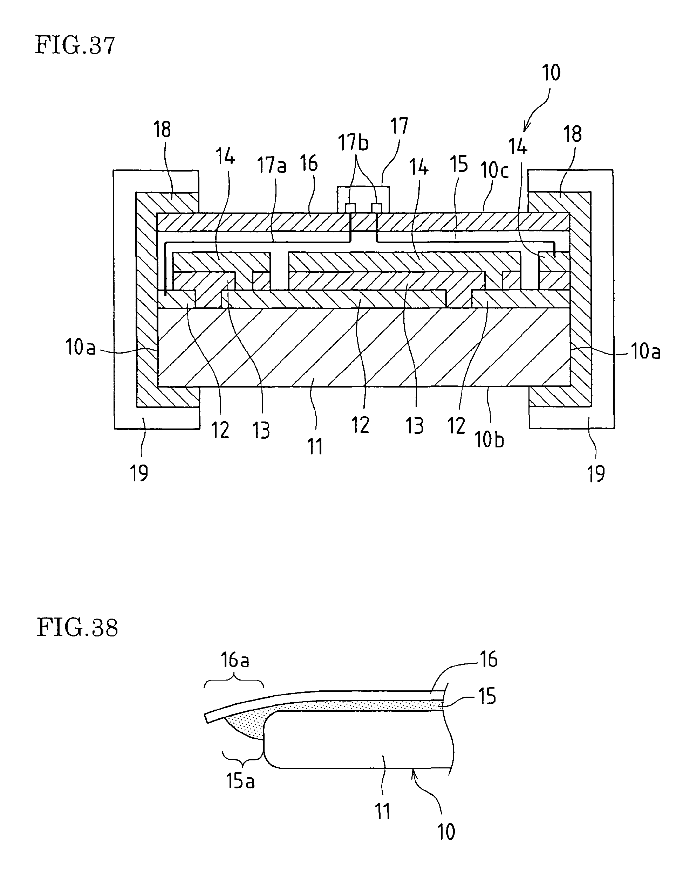

FIG. 37 is a cross-sectional view schematically showing an example structure of a thin-film solar module 10.

The thin-film solar module (hereinafter simply referred to as a module) 10 of FIG. 37 includes a glass substrate 11, a front electrode 12 formed on the glass substrate 11, a solar cell 13 that is a semiconductor layer formed on the front electrode 12, a rear electrode 14 formed on the solar cell 13, EVA 15 serving as a first sealing member, and a back sheet 16 serving as a second sealing member, which are successively formed in this stated order (the glass substrate 11 is closest to the light reception side (a surface 10b)). Leads 17a are connected to opposite end portions of the solar cell 13 so that power can be extracted from terminals 17b provided in a terminal box 17. In order to seal these components at an end face 10a, an end-face sealing member 18 is provided on the end face 10a of the module 10. An aluminum frame 19 serving as a sealing protection frame surrounds the components with the end-face sealing member 18 being interposed therebetween. Note that, in the module 10 of FIG. 37, the glass substrate (hereinafter simply referred to as a substrate) 11 on which the front electrode 12, the rear electrode 14, and the solar cell 13 are mounted may be attached only to the back sheet 16 without the EVA 15.

FIG. 38 is a cross-sectional view schematically showing the module 10 in which the EVA 15 and the back sheet 16 are attached to the substrate 11, in a process of manufacturing the module 10.

In the process of manufacturing the module 10, as shown in FIG. 38, in the module 10 in which the EVA 15 and the back sheet 16 are attached to the substrate 11 (the substrate 11 is sealed by the EVA 15 and the back sheet 16), a portion of the EVA 15 and the back sheet 16 protrudes from an outer edge portion of the substrate 11. Note that, in FIG. 38, a reference numeral 15a indicates an excess portion of the EVA 15 protruding from the outer edge portion of the substrate 11, and a reference numeral 16a indicates an excess portion of the back sheet 16 protruding from the outer edge portion of the substrate 11.

During the manufacture of the module 10, after the substrate 11 has been sealed by the EVA 15 and the back sheet 16, the excess portions 15a and 16a protruding from the outer edge portion of the substrate 11 need to be removed (trimming step).

For example, Patent Document 1 describes a trimming technique of cutting off the excess portions 15a and 16a as follows. A knife-like cutter plate elongating in one direction is used as a cutting means. The knife-like cutter plate is vertically vibrated by ultrasound (see paragraph [0060]). Patent Document 1 also describes that, in the trimming process, the excess portion is cut by the cutter plate that is in an inclined position, whereby the cutter plate can be used as a scraper to move the cut excess portion away from the sides of the substrate of the sealed module. In addition, even if the thermoplastic excess portion is melted by heat generated by the cutting, the excess portion can be prevented from being attached back to the module (see paragraph [0061]). Moreover, Patent Document 1 describes that a circular saw or a dicing cutter is used as the cutting means (see paragraph [0025]).

### Cited List

### Patent Document

Patent Document 1: JP 2001-320069 A

### Disclosure of Invention

### Problem to be Solved by the Invention

After the trimming step, an end face sealing step is performed to seal the end face 10a of the module 10 with the end-face sealing member 18.

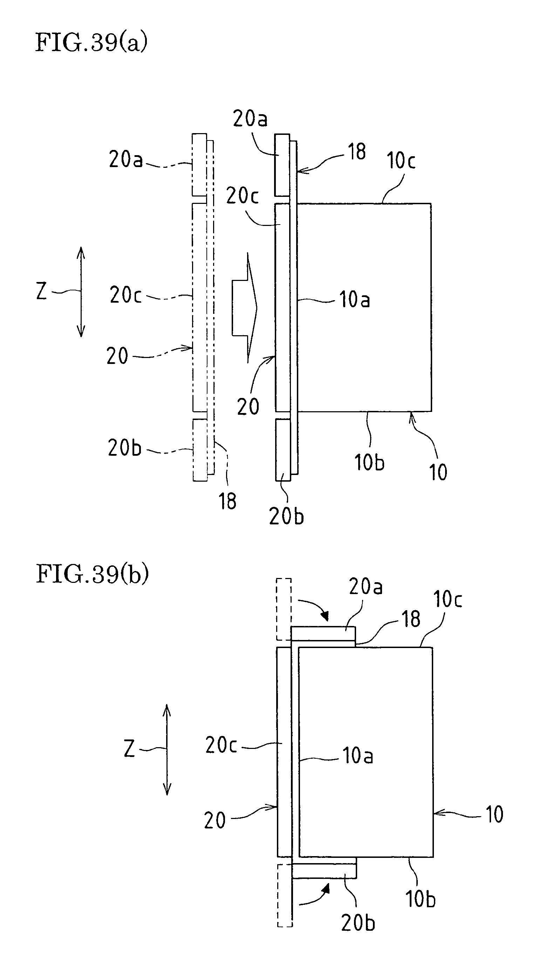

FIG. 39 is a schematic side view for describing an example step of sealing the end face 10a of the module 10 with the end-face sealing member 18. FIG. 39(a) shows a middle portion (in a thickness direction (Z direction) of the module 10) of the end-face sealing member 18 that is attached to the end face 10a of the module 10. FIG. 39(b) shows opposite end portions (in the thickness direction (Z direction) of the module 10) (see portions in the vicinity of opposite end portions 20a and 20b of a suction head (holding means) 20 of FIG. 39) of the end-face sealing member 18 that are attached to the face 10b and the rear face 10c of the module 10.

As shown in FIG. 39, in the end face sealing step, the suction head 20 whose opposite end portion 20a and 20b in the thickness direction (Z direction) of the module 10 can be bent holds the end-face sealing member 18, and the suction head 20 holding the end-face sealing member 18 is moved to approach the end face 10a of the module 10 while the suction head 20 is kept parallel to the end face 10a, whereby the end-face sealing member 18 at the middle portion 20c of the suction head 20 is attached to the end face 10a of the module 10 (see FIG. 39(a)). Thereafter, the opposite end portions 20a and 20b of the suction head 20 are bent by 90° with respect to the middle portion 20c, whereby the opposite end portions of the end-face sealing member 18 held by the opposite end portions 20a and 20b of the suction head 20 are attached to the face 10b and the rear face 10c of the module 10 (see FIG. 39(b)).

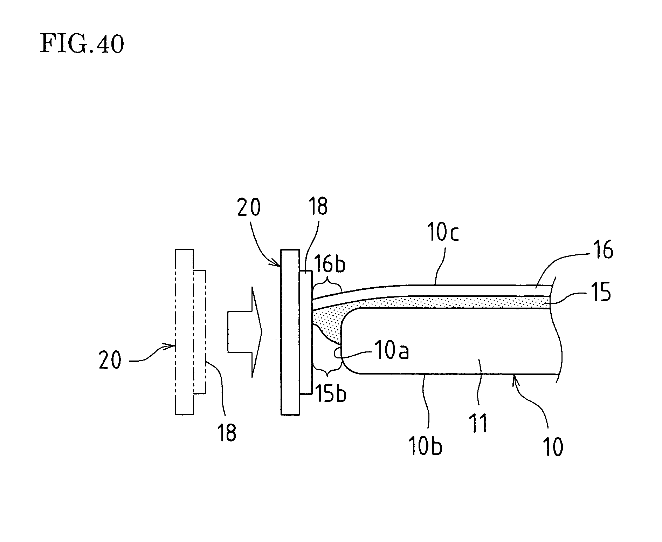

In the end face sealing step of FIG. 39, when the end-face sealing member 18 is attached to the module 10, the end-face sealing member 18 hangs on residual portions 15b and 16b (defective attachment), depending on the residual amount of the residual portions 15b and 16b (see FIG. 40).

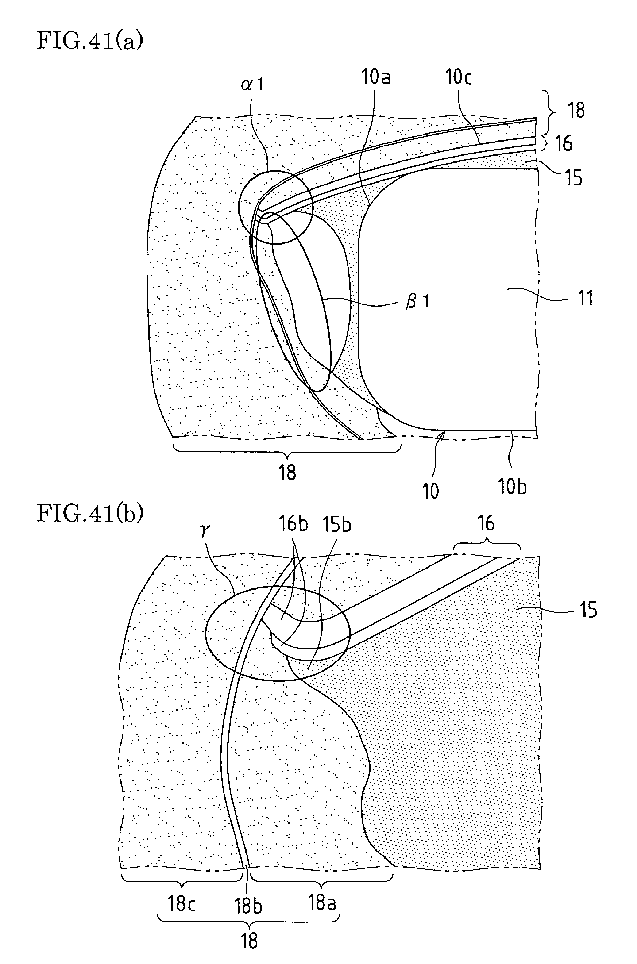

FIG. 40 is a schematic cross-sectional view for describing a problem that may arise in the end face sealing step due to the residual amount of the residual portions 15b and 16b occurring in the trimming step. FIG. 41 is an enlarged cross-sectional view of a portion including the end face 10a of the module 10 of FIG. 40. FIG. 41(a) shows the portion including the end face 10a of the module 10 of FIG. 40, and FIG. 41(b) is an enlarged view of a portion α1 of FIG. 41(a).

As shown in FIG. 41, in this example, the back sheet 16 includes two layers, and the end-face sealing member 18 includes three layers, i.e., a butyl layer 18a, a polyethylene terephthalate (PET) layer 18b having a thickness of about 17 µm, and a foam layer 18c.

If the residual amount of the residual portions 15b and 16b occurring in the trimming step is large or unstable (non-uniform), the end-face sealing member 18 makes line contact with the residual portions 15b and 16b, and therefore, a sufficient area in which the end-face sealing member 18 is attached to the end face 10a of the module 10 cannot be ensured. In this case, the end-face sealing member 18 hangs on the residual portions 15b and 16b, likely leading to a defective attachment (see a portion β1 in FIG. 41(a)). The end-face sealing member 18 also has a role in ensuring insulation from the module 10. However, if the residual amount is large, there is a high risk that the residual portions 15b and 16b penetrate the end-face sealing member 18 (see a portion γ in FIG. 41(b)). For example, if the residual portions 15b and 16b penetrate the end-face sealing member 18 and break the end-face sealing member 18, the resistance to breakdown is likely to be defective.

In this regard, the trimming process of Patent Document 1 cuts off the excess portion by moving the cutter plate that is vibrated vertically with respect to the substrate by ultrasound, along a perimeter of the module. When the excess portion is cut, the cutter plate vibrates vertically due to ultrasound. Therefore, the upward and downward movements of the cutter plate are repeatedly performed in an alternating manner. When the movement direction is changed, the cutter is instantaneously stopped. Here, the excess portion is cut off when the cutter plate moves up or down. Therefore, shear stress is not uniform. For example, if the back sheet is formed of multilayer aluminum metal foil, the cut surface has a corrugated shape (ridges and grooves), i.e., the cut surface is rough. As a result, the residual amount is not stable, disadvantageously likely leading to a defective attachment and a defective resistance to breakdown of the end face sealing member.

Therefore, it is an object of the present invention to provide a trimming method and device for removing an excess portion of a sealing member that is used to seal a substrate of a module, in which the amount of a residual portion is stable, and therefore, defects caused from variations in the residual amount (e.g., a defective attachment and a defective resistance to breakdown of an end face sealing member, etc.) can be effectively prevented.

### Means for Solving Problem

The present inventor has extensively studied in order to achieve the object, and has found the following.

Specifically, when an excess portion of a sealing member that seals a substrate of a module is removed, a rotating blade having an outer circumferential blade edge that has a sloped surface to become gradually narrower in a blade thickness direction outward in a radial direction is used to cut the excess portion while the rotating blade is being rotated in one direction. Unlike conventional knife-shaped cutter plates, the cutter is never instantaneously stopped, and therefore, the shear stress is uniform, and therefore, a rough cut surface can be reduced, whereby the residual amount can be stabilized. If the excess portion is cut by the rotating blade that is rotated in one direction and is parallel to the cutting direction along the end face of the substrate, the rotating blade rotating in one direction is likely to wobble in the rotating shaft direction due to a force acting in a direction away from the substrate, and therefore, the residual amount varies significantly, and in some cases, the cut surface becomes rough. Therefore, if the excess portion is cut by the rotating blade rotating in one direction that is inclined about an axis along the thickness direction of the substrate toward the substrate at a cutting angle, the wobbling in the rotating shaft direction of the rotating blade can be reduced, whereby the residual amount can be proportionately stabilized.

It is based on the above finding that the present invention has been made. To achieve the object, the following module trimming method and device are provided.

### (1) Module Trimming Method

A module trimming method according to the present invention is a trimming method for removing an excess portion of a sealing member that seals a substrate of a module. In the method, a rotating blade having a blade edge that has a sloped surface to become gradually narrower in a blade thickness direction outward along a radial direction is inclined about an axis along a thickness direction of the substrate toward the substrate at a cutting angle, and the excess portion is cut off by relatively moving at least one of the rotating blade and the module in a cutting direction along an end face of the substrate while the rotating blade is being rotated in one direction.

### (2) Module Trimming Device

A module trimming device according to the present invention is a trimming device for removing an excess portion of a sealing member that seals a substrate of a module. The device includes a rotating blade having a sloped surface to become gradually narrower in a blade thickness direction outward along a radial direction, a rotating blade support portion that supports the rotating blade with the rotating blade being inclined about an axis along a thickness direction of the substrate toward the substrate at a cutting angle, a rotation drive portion that rotates the rotating blade in one direction, and a cutting movement portion relatively moves at least one of the rotating blade and the module in a cutting direction along an end face of the substrate.

According to the present invention, the rotating blade is inclined about an axis along the thickness direction of the substrate toward the substrate at the cutting angle, and the excess portion is cut off by relatively moving at least one of the rotating blade and the module in the cutting direction while the rotating blade is being rotated in one direction. Therefore, the residual amount can be stabilized. As a result, the occurrence of defects caused by variations in the residual amount, such as a defective attachment and a defective resistance to breakdown of the end-face sealing member, can be effectively prevented. In addition, the blade edge of the rotating blade has a sloped surface to become gradually sharper (i.e., narrower in the blade thickness direction) outward in the radial direction. Therefore, loading and a rough cut surface that would occur if a circular saw is used can be avoided. If a circular saw is used, not only loading is likely to occur quickly, but also the cut surface is likely to be rough, and therefore, the residual amount is not stable. Therefore, circular saws are not suitable for mass production. Conventional knife-shaped cutter plates have a short effective cutter length and therefore a short life. In the present invention, the rotating blade is used as a cutting means, and therefore, the effective length is π (about 3.14) times the diameter. As a result, the cutting means can be used for a longer period of time, which it is difficult for conventional knife-shaped cutter plates to achieve. If a dicing cutter is employed, the dicing cutter requires diamond and therefore cost is high, and in addition, the substrate is highly likely to be damaged. Therefore, the dicing cutter is not suitable for an unreinforced substrate or a thin film-like substrate. Patent Document 1 describes that the cutter is vibrated by ultrasound "at an output power of 150 W or more" (paragraph [0060]). This output power is high, and therefore, the cutter of Patent Document 1 is not suitable for mass production in terms of cost. It is preferable that a cutter be driven at a low output power in terms of safety during maintenance (e.g., replacement of a worn component). In contrast to this, according to the present invention, the rotating blade is rotated in one direction. Therefore, for example, a drive motor with low power consumption can be employed. As a result, the cutting means can be driven at low power. Therefore, lower power consumption can be achieved and safety during maintenance can be ensured. Although circular saws and dicing cutters are difficult to resharpen, the rotating blade that is easily resharpened can be employed in the present invention, and therefore, the running cost of the cutting means can be proportionately reduced. Thus, according to the present invention, the life of the cutting means can be increased, and the cutting means can be driven at low power, and therefore, lower power consumption can be achieved and safety during maintenance can be ensured, and in addition, the running cost of the cutting means can be reduced.

In the present invention, as the cutting angle of the rotating blade increases, the rotating blade is likely to receive a proportionately larger force in a rotation axis direction (a direction in which the rotating blade is bent). Therefore, if the force is large, the rotating blade is likely to be bent toward the rotation axis direction, likely leading to wear or a decrease in the life of the blade edge. On the other hand, as the cutting angle of the rotating blade approaches 0°, the rotating blade receives a force acting in a direction away from the end face of the substrate, likely leading to an increase in the residual amount. Therefore, in the present invention, the cutting angle of the rotating blade may fall within the range of 0.6° to 10°.

In the present invention, when the excess portion is cut, the rotating blade preferably has a tangential speed being within the range of 2.0 m/s to 5.5 m/s. If the tangential speed is less than 2.0 m/s, the cut surface of the sealing member is likely to be rough, and the residual amount tends to increase and significantly vary. On the other hand, if the tangential speed is more than 5.5 m/s, the frictional resistance to the sealing member (e.g., ethylene-vinyl acetate (EVA)) during the cutting is likely to increase, and therefore, a large portion of the sealing member is likely to be melted, so that the melted sealing member tends to adhere to the blade edge of the rotating blade, leading to a significant decrease in cutting performance.

In the present invention, when the excess portion is cut, a relative movement speed between the rotating blade and the module preferably is the range of 233.3 mm/s or less. If the relative movement speed exceeds 233.3 mm/s, the cut surface of the sealing member is likely to be rough, and the residual amount increases and significantly varies.

In the present invention, an uplift restriction member may be provided to restrict uplift of the excess portion cut off by the rotating blade. In other words, the trimming device of the present invention may include an uplift restriction member that restricts uplift of the excess portion cut off by the rotating blade.

In this aspect, the uplift restriction member can be used to restrict uplift of the excess portion caused by the shear stress of the rotating blade, thereby allowing the rotating blade to smoothly cut the excess portion. Note that, when the excess portion is cut by the rotating blade, a distance (press height) between an upper face of a portion corresponding to the substrate of the module and a contact surface of the uplift restriction member with respect to the excess portion preferably is within the range of -1.0 mm to 0 mm, more preferably about -0.5 mm. Here, negative values of the press height indicate that the contact surface of the uplift restriction member with respect to the excess portion is closer to the rotating shaft of the rotating blade than the upper face of the module is.

In the present invention, if the tip angle of the blade edge is excessively small, the blade edge has difficulty in maintaining the stiffness. If the tip angle of the blade edge is excessively large, the cutting performance is likely to decrease. Therefore, in the present invention, the tip angle of the blade edge may fall within the range of 10° to 30°.

In the present invention, a holding roller may be provided to hold the module on one surface thereof without being in contact with the rotating blade. Specifically, the trimming device of the present invention preferably includes a holding roller that holds the module on one surface thereof without being in contact with the rotating blade.

In this aspect, when the holding roller holds the module, the holding roller is not in contact with the rotating blade, and therefore, load to the rotating blade due to the contact of the holding roller can be avoided. As a result, deformation of the rotating blade can be reduced, whereby the residual amount can be proportionately stabilized. In addition, the excess portion can be cut by the rotating blade while the holding roller holds the substrate. As a result, even if the module has a non-uniform thickness or the cut position in the thickness direction of the module is slightly different due to warpage of the substrate, variations in the thickness of the sealing member, etc., the excess portion can be cut while a position relationship between the rotating blade and the substrate in the thickness direction of the substrate is maintained constant.

In the present invention, the holding roller may have a roller portion, and a step-like portion provided along a circumferential direction and protruding from the roller portion outward in the radial direction.

In this aspect, the holding roller has the roller portion and the step-like portion. Therefore, the contact area between the outer circumferential face of the holding roller and the module can be reduced, whereby the positioning accuracy of the height position of the rotating blade can be improved.

In the present invention, the rotating blade may be rotated in the same direction (forward) as the cutting direction or in a direction (backward) opposite to the cutting direction. Specifically, in the trimming device of the present invention, the rotation drive portion preferably rotates the rotating blade in the same direction as the cutting direction or in the direction opposite to the cutting direction.

In this aspect, when the direction of rotation of the rotating blade is forward, the wear of the blade edge of the rotating blade can be reduced, and therefore, the cutting efficiency can be improved. The residual amount can also be more stabilized than when the direction of rotation of the rotating blade is backward. On the other hand, when the direction of rotation of the rotating blade is backward, chips of the excess portion are emitted in the direction opposite to the cutting direction. Therefore, the chips less obstruct the cutting of the excess portion performed by the rotating blade.

In the present invention, at least one of the rotating blade and the module may be relatively moved along the thickness direction of the substrate. Specifically, the trimming device of the present invention may include a thickness direction movement portion relatively moves at least one of the rotating blade and the module in the thickness direction of the substrate.

In this aspect, by setting the center of rotation of the rotating blade to be lower or higher than the module, the direction of rotation of the rotating blade can be easily set to be forward or backward. Note that, when the cutting is performed using the rotating blade, the length of the excess portion is preferably 3 mm or more if the rotation of the rotating blade is backward and 1 mm or more if the rotation of the rotating blade is forward.

In the present invention, the excess portion may be cut off by the rotating blade that is inclined about an axis along the cutting direction toward the substrate at an inclination angle. Specifically, in the trimming device of the present invention, the cutting movement portion may relatively move at least one of the rotating blade and the module in the cutting direction with the rotating blade being inclined about an axis along the cutting direction toward the substrate at an inclination angle.

In this aspect, the excess portion is cut off by the rotating blade that is inclined about an axis along the cutting direction toward the substrate at an inclination angle, whereby a resistance force received from the front of the rotating blade can be distributed. As a result, the rotating blade can be prevented from being displaced from the substrate.

In the present invention, a pair of the rotating blades may be provided so that excess portions on two opposite sides of the substrate are simultaneously cut off.

In this aspect, a pair of rotating blades are provided so that excess portions on two opposite sides of the substrate are simultaneously cut off. Therefore, excess portions on two opposite sides of the substrate can be simultaneously cut off, whereby the processing rate can be improved.

In the present invention, when the inclination angle of the rotating blade is 0° (the rotating blade is perpendicular to the substrate), the rotating blade is likely to be deformed outward, i.e., in a direction away from the substrate. On the other hand, as the inclination angle of the rotating blade increases, a cutting length of the rotating blade with respect to the excess portion increases, likely leading to the decrease in the life of the rotating blade. Therefore, in the present invention, the inclination angle of the rotating blade may fall within the range of 0° or more and 15° or less

In the present invention, a rotating shaft of the rotation drive portion may be covered by a rotating shaft cover. Specifically, the trimming device of the present invention may include a rotating shaft cover that covers a rotating shaft of the rotation drive portion.

In this aspect, the rotating shaft cover can prevent the rotating shaft of the rotation drive portion from being exposed. As a result, the excess portion can be prevented from getting entangled with the rotating shaft of the rotation drive portion.

In the present invention, chips of the excess portion that has been cut off may be blown off by an air blow device. Specifically, the trimming device of the present invention may include an air blow device blows off chips of the excess portion that has been cut off.

In this aspect, the air blow device is directed toward a cutting point (target) (e.g., a downstream end in the cutting direction of a contact portion of the rotating blade with respect to the excess portion) of the rotating blade, whereby chips that may occur immediately after the cutting can be easily blown off.

In the present invention, chips of the excess portion that has been cut off may be sucked by a dust suction device. Specifically, the trimming device of the present invention may include a dust suction device suctions chips of the excess portion that has been cut off.

In this aspect, the dust suction device is directed toward a cutting point (target) (e.g., a downstream end in the cutting direction of a contact portion of the rotating blade with respect to the excess portion) of the rotating blade, whereby chips that may occur immediately after the cutting can be easily sucked.

Examples of a material for the rotating blade include, but are not limited to, tool steel (SK) and high speed steel.

Representative examples of the sealing member include ethylene-vinyl acetate (EVA) and a back sheet. A material for EVA is effective to, for example, a composition described in JP 2006-134969 A.

Specifically, the material for EVA may be a copolymer of ethylene (major component) and a monomer copolymerizable therewith. Examples of such a copolymer include a copolymer of ethylene and a vinyl ester (e.g., vinyl acetate, vinyl propionate, etc.), a copolymer of ethylene and an unsaturated carboxylic acid ester (e.g., methyl acrylate, ethyl acrylate, isobutyl acrylate, n-butyl acrylate, methyl methacrylate, etc.), a copolymer of ethylene and an unsaturated carboxylic acid (e.g., acrylic acid, methacrylic acid, etc.), or an ionomer thereof, a copolymer of ethylene and an α-olefin (e.g., propylene, 1-butene, 1-hexene, 1-octene, 4-methyl-1-pentene, etc.), or a combination of two or more thereof.

As the back sheet, monolayer back sheets (a polyethylene terephthalate (PET)-based layer) and three-layer back sheets (a PET-based layer/a metal foil or a metal oxide layer/a PET-based layer) are known. The back sheet is formed of materials described in JP 2009-188299 A.

Specifically, the material for the back sheet can be selected from polyester bases selected from polyethylene terephthalate (PET), polyethylene naphthalate (PEN), polybutylene terephthalate (PBT), and polycyclohexane dimethanol terephthalate (PCT), polycarbonate bases, or acrylic bases. The material for the back sheet may also be appropriately selected from other substances, such as polyolefin resins, polyamide resins, and polyacrylate resins, taking into consideration heat resistance, strength properties, electrical insulation properties, or the like.

A material for the fluoropolymer film may be appropriately selected from, for example, polyvinyl fluoride (PVF), polyvinylidene fluoride (PVDF), polychlorotrifluoroethylene (PCTFE), polyethylenetetrafluoroethylene (ETFE), polytetrafluoroethylene (PTFE), tetrafluoroethylene-perfluoroalkylvinyl ether copolymer (PFA), tetrafluoroethylene-hexafluoropropylene copolymer (FEP), or a film or sheet of an acrylic modification of these fluoropolymers.

The metal oxide deposition layer or the metal foil layer may be selected from, for example, silicon oxide or aluminum oxide, copper, aluminum foil, and the like.

### Effects of the Invention

As described above, according to the present invention, the residual amount can be stabilized. As a result, the occurrence of defects due to variations in the residual amount, such as a defective attachment and a defective resistance to breakdown of the end-face sealing member, can be effectively prevented.

### Brief Description of Drawings

[FIG. 1] FIG. 1 is a plan view schematically showing a configuration of a trimming device according to a first embodiment of the present invention that performs a trimming method for removing an excess portion of a module.
[FIG. 2] FIG. 2 is a schematic plan view for describing an example step of removing excess portions on the longer sides of a sealing member in the module.
[FIG. 3] FIG. 3 is a schematic plan view for describing an example step of removing excess portions on the shorter sides of a sealing member in the module.
[FIG. 4] FIG. 4 is a cross-sectional view mainly showing an excess portion cutting mechanism, taken along line A-A of the trimming device of FIG. 1.
[FIG. 5] FIG. 5 is a diagram showing how an excess portion is being cut by a rotating blade. FIG. 5(a) is a schematic cross-sectional view thereof. FIG. 5(b) is a schematic plan view thereof. FIG. 5(c) is a schematic side view of a portion including a rotating blade of the trimming device of FIG. 1, as viewed from the interior in a direction of a rotating shaft.
[FIG. 6] FIG. 6 is a diagram for describing a preferable value of a cutting angle of the rotating blade. FIG. 6(a) is a diagram showing a force acting on the rotating blade when the cutting angle of the rotating blade is excessively large. FIG. 6(b) is a diagram showing a force acting on the rotating blade when the cutting angle of the rotating blade is excessively small.
[FIG. 7] FIG. 7 is a schematic cross-sectional view showing how an end face of the module is sealed by an end-face sealing member in an end face sealing step.
[FIG. 8] FIG. 8 is an enlarged cross-sectional view of the end face of the module sealed by the end-face sealing member in the end face sealing step.
[FIG. 9] FIG. 9 is a side view schematically showing an example blade edge of the rotating blade having two different slope portions.
[FIG. 10] FIG. 10 is a side view schematically showing a portion of an excess portion that is cut by the rotating blade of the trimming device.
[FIG. 11] FIG. 11 is a schematic side view for describing the direction of rotation of the rotating blade with respect to a cutting direction. FIG. 11(a) is a diagram showing how the rotating blade is rotated in the same direction (forward direction) as the cutting direction. FIG. 11(b) is a diagram showing how the rotating blade is rotated in a direction (backward direction) opposite to the cutting direction.
[FIG. 12] FIG. 12 is a diagram for describing how an excess portion is being cut by the rotating blade that is inclined about an axis along the cutting direction so that the blade edge leans toward the substrate. FIG. 12(a) is a schematic side view of a portion including the rotating blade of the trimming device. FIG. 12(b) is an enlarged side view of a cut portion of the excess portion.
[FIG. 13] FIG. 13 is a side view schematically showing a portion including the rotating shaft in a case where a rotating blade support portion is provided with an example rotating shaft cover for covering the rotating shaft.
[FIG. 14] FIG. 14 is a side view schematically showing an air blow device provided in the trimming device. FIG. 14(a) shows an example of the air blow device. FIG. 14(b) shows another example of the air blow device.
[FIG. 15] FIG. 15 is a diagram schematically showing an example first dust suction device provided in the trimming device. FIG. 15(a) is a side view thereof. FIG. 15(b) is a cross-sectional view thereof.
[FIG. 16] FIG. 16 is a side view schematically showing an example second dust suction device provided in the trimming device.
[FIG. 17] FIG. 17 is a schematic side view showing chips and an excess portion after the cutting when the direction of rotation of the rotating blade is backward, in the trimming device including the second dust suction device.
[FIG. 18] FIG. 18 is a schematic side view showing chips and an excess portion after the cutting when the direction of rotation of the rotating blade is forward, in the trimming device including the second dust suction device.
[FIG. 19] FIG. 19 is a diagram showing an experimental machine that was used to clarify optimum conditions for the cutting angle of the rotating blade during the cutting of an excess portion. FIG. 19(a) is a schematic plan view of the experimental machine. FIG. 19(b) is a schematic plan view of a portion including a rotating blade of the experimental machine.
[FIG. 20] FIG. 20 is a plan view showing an excess portion of a module after being cut by the rotating blade in the experimental machine of FIG. 19. FIG. 20(a) is a diagram showing the cutting angle of the rotating blade and a gap between the blade edge of the rotating blade and the substrate. FIG. 20(b) is a diagram showing the residual amounts of a residual portion after the cutting by the rotating blade.
[FIG. 21] FIG. 21 is a diagram for describing facilitation of adjustment of the cutting angle. FIG. 21(a) is a side view showing a first distance in a Y (X) direction of a portion of the rotating blade that overlaps the substrate, as viewed in a direction of the rotating shaft. FIG. 21(b) is a plan view showing a second distance in an X (Y) direction between a downstream end portion and an upstream end portion in the cutting direction of a portion of the rotating blade that overlaps the substrate. FIG. 21(c) is a table showing values of the second distance for obtaining the cutting angle.
[FIG. 22] FIG. 22 is a graph showing residual amounts and a cutting resistance, where a sealing member included only a back sheet, and a gap between the blade edge of the rotating blade and the substrate was 0.2 mm. FIGS. 22(a) and 22(b) are graphs showing the residual amounts with respect to the cutting angle, where the direction of rotation of the rotating blade was backward and forward, respectively. FIGS. 22(c) and 22(d) are graphs showing a tensile force with respect to the cutting angle, where the direction of rotation of the rotating blade was backward and forward, respectively.

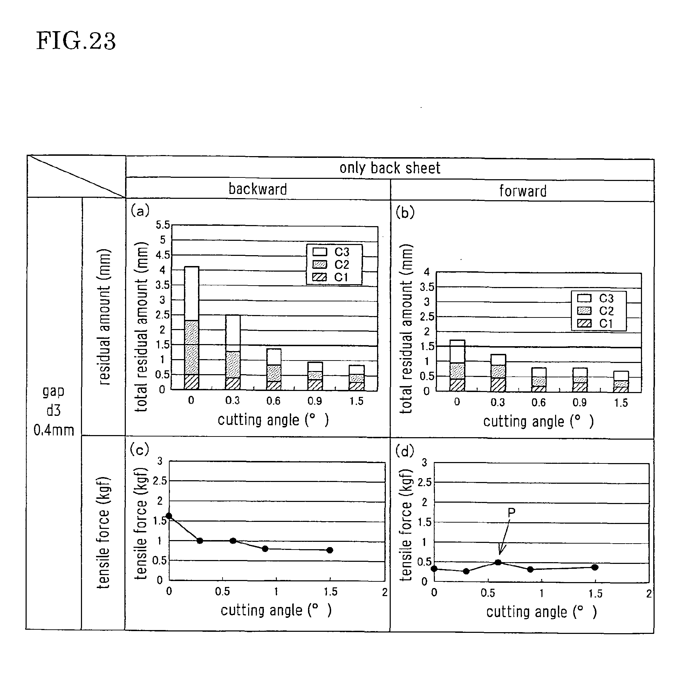

[FIG. 23] FIG. 23 is a graph showing the residual amounts and the cutting resistance, where the sealing member included only a back sheet, and the gap between the blade edge of the rotating blade and the substrate was 0.4 mm. FIGS. 23(a) and 23(b) are graphs showing the residual amounts with respect to the cutting angle, where the direction of rotation of the rotating blade was backward and forward, respectively. FIGS. 23(c) and 23(d) are graphs showing the tensile force with respect to the cutting angle, where the direction of rotation of the rotating blade was backward and forward, respectively.

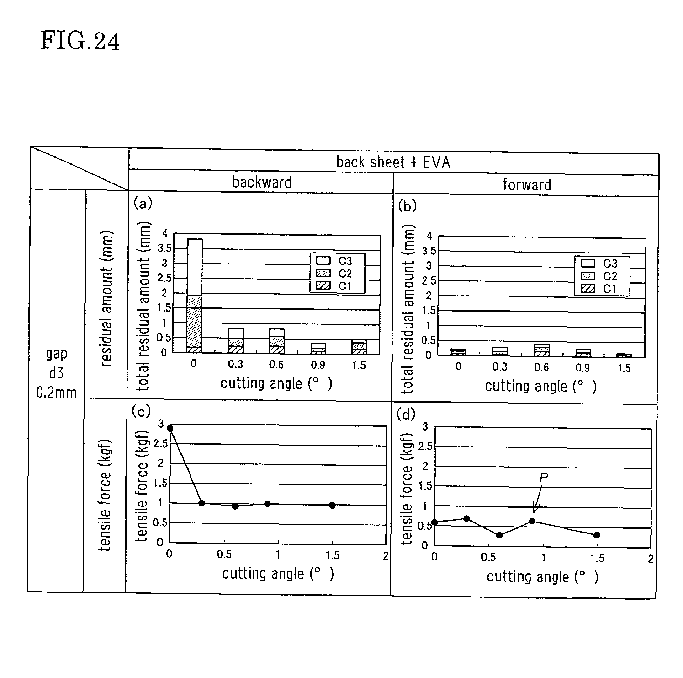

[FIG. 24] FIG. 24 is a graph showing the residual amounts and the cutting resistance, where the sealing member included EVA and a back sheet, and the gap between the blade edge of the rotating blade and the substrate was 0.2 mm. FIGS. 24(a) and 24(b) are graphs showing the residual amounts with respect to the cutting angle, where the direction of rotation of the rotating blade was backward and forward, respectively. FIGS. 24(c) and 24(d) are graphs showing the tensile force with respect to the cutting angle, where the direction of rotation of the rotating blade was backward and forward, respectively.

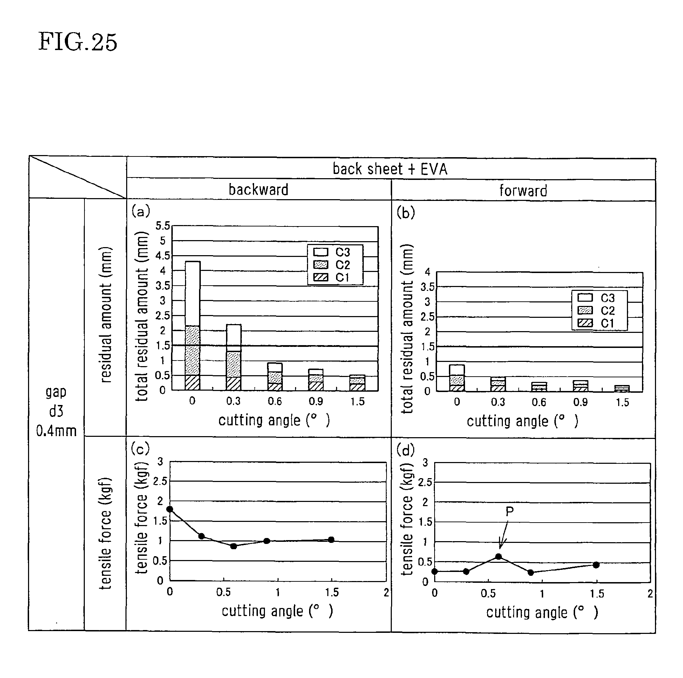

[FIG. 25] FIG. 25 is a graph showing the residual amounts and the cutting resistance, where the sealing member included EVA and a back sheet, and the gap between the blade edge of the rotating blade and the substrate was 0.4 mm. FIGS. 25(a) and 25(b) are graphs showing the residual amounts with respect to the cutting angle, where the direction of rotation of the rotating blade was backward and forward, respectively. FIGS. 25(c) and 25(d) are graphs showing the tensile force with respect to the cutting angle, where the direction of rotation of the rotating blade was backward and forward, respectively.
[FIG. 26] FIG. 26 is a graph showing the residual amounts of a comparative example and the residual amounts of Example 1.
[FIG. 27] FIG. 27 is an enlarged schematic plan view of a cutting start portion of the module after an excess portion of the module had been cut. FIG. 27(a) is a diagram showing Example 2 in which an uplift restriction member was not provided. FIG. 27(b) is a diagram showing Example 3 in which an uplift restriction member was provided.
[FIG. 28] FIG. 28 is a diagram for describing Example 4 in which the state of a cut surface obtained by the rotating blade was studied by changing a protruding amount of the back sheet and a press height of the uplift restriction member. FIG. 28(a) is a diagram showing conditions for the experiment of Example 4. FIG. 28(b) is a table showing the result of the experiment of Example 4.
[FIG. 29] FIG. 29 is a plan view schematically showing a configuration of a trimming device according to a second embodiment of the present invention.
[FIG. 30] FIG. 30 is a schematic plan view for describing a process of removing an excess portion by a trimming process. FIG. 30(a) is a diagram for describing how excess portions on the longer sides are cut. FIG. 30(b) is a diagram for describing how excess portions on the shorter sides are cut.
[FIG. 31] FIG. 31 is a cross-sectional view taken along arrows A-A of FIG. 29, mainly showing a cutting movement portion support mechanism.
[FIG. 32] FIG. 32 is a cross-sectional view mainly showing an excess portion cutting mechanism, taken along arrows B-B of FIG. 29.
[FIG. 33] FIG. 33 is a schematic side view of a portion including a rotating blade of the trimming device of FIG. 29, as viewed from the interior in a direction of a rotating shaft.
[FIG. 34] FIG. 34 is a side view schematically showing an example blade edge of the rotating blade having two different slope portions.
[FIG. 35] FIG. 35 is a side view schematically showing a portion of an excess portion that is cut by the rotating blade of the trimming device.
[FIG. 36] FIG. 36 is a diagram for describing a technique of cutting off an excess portion of a module using an electric heating wire.
[FIG. 37] FIG. 37 is a cross-sectional view schematically showing an example structure of a thin-film solar module.
[FIG. 38] FIG. 38 is a cross-sectional view schematically showing a module in which EVA and a back sheet are attached to a substrate, in a process of manufacturing the module.
[FIG. 39] FIG. 39 is a schematic side view for describing an example step of sealing an end face of a module with an end-face sealing member. FIG. 39(a) is a diagram showing a middle portion (in a thickness direction of the module) of the end-face sealing member that is attached to the end face of the module. FIG. 39(b) is a diagram showing opposite end portions (in the thickness direction) of the end-face sealing member that are attached to a surface and a rear face of the module.
[FIG. 40] FIG. 40 is a schematic cross-sectional view for describing a problem that may arise in the end face sealing step due to the amount of a residual portion occurring in a trimming step.
[FIG. 41] FIG. 41 is an enlarged cross-sectional view of a portion including the end face of the module of FIG. 40. FIG. 41(a) is a diagram showing the portion including the end face of the module of FIG. 40. FIG. 41(b) is an enlarged view of a portion α1 of FIG. 41(a).

### Description of the Invention

Embodiments of the present invention will be described hereinafter with reference to the accompanying drawings. The embodiments described below are specific examples of the present invention and are not intended to limit the scope of the present invention.

### - First Embodiment -

### (Overall Configuration of Trimming Device)

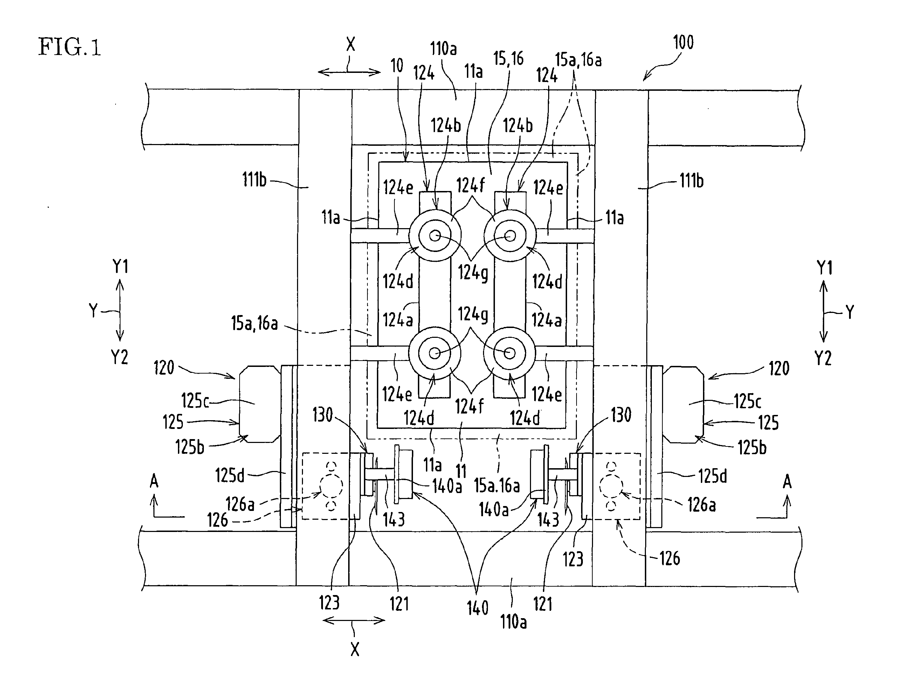

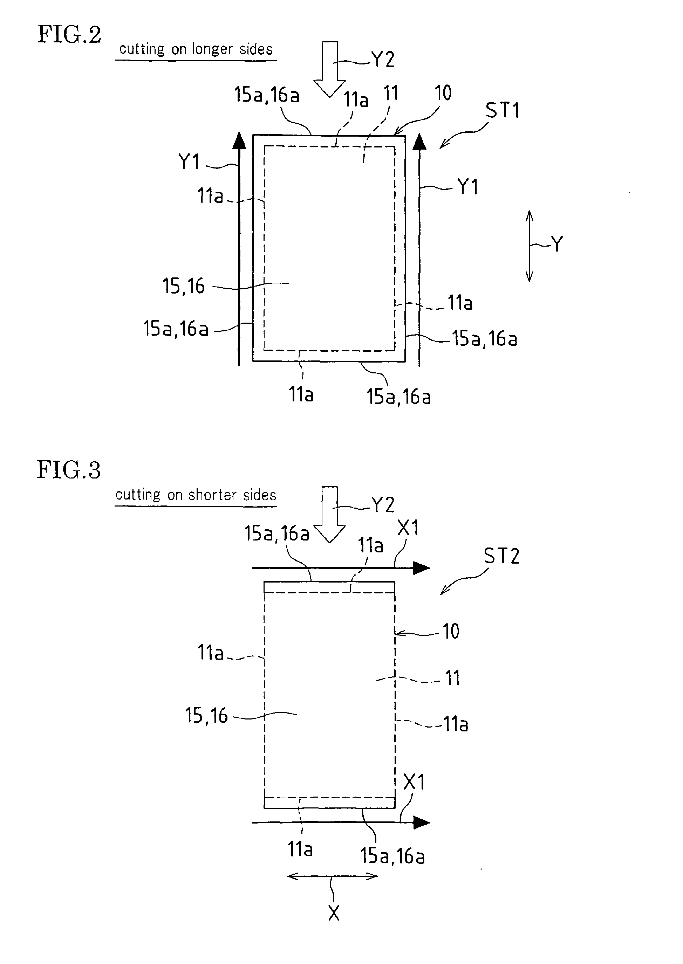

FIG. 1 is a plan view schematically showing a configuration of a trimming device 100 according to a first embodiment of the present invention that performs a trimming method for removing excess portions 15a and 16a of a module 10. FIG. 2 is a schematic plan view for describing an example step of removing the excess portions 15a and 16a on the longer sides of sealing members 15 and 16 (here, an EVA 15 and a back sheet 16, hereinafter referred to as the EVA 15 and the back sheet 16) in the module 10. FIG. 3 is a schematic plan view for describing an example step of removing the excess portions 15a and 16a on the shorter sides of the sealing members 15 and 16 in the module 10.

Here, the module 10 is similar to that shown in FIG. 37. Therefore, the same parts as those of FIG. 37 are indicated by the same reference numerals and the module 10 will not be described again in detail.

As shown in FIG. 2, the trimming device 100 transports the module 10 in a transport direction (a Y2 direction in FIG. 2) toward a first stage ST1, and lifts up the module 10 onto the first stage ST1.

On the first stage ST1, two opposite sides (along a Y direction, here the longer sides) of the substrate 11 in the module 10 are simultaneously cut in a cutting direction (a Y1 direction) along end faces 11a and 11a of the substrate 11. Thereafter, as shown in FIG. 3, the trimming device 100 transports the module 10 in the transport direction Y2 toward a second stage ST2, and lifts up the module 10 onto the second stage ST2. Thereafter, the other two opposite sides (along an X direction, here the shorter sides) are simultaneously cut in a cutting direction (an X1 direction) on the second stage ST2.

Note that the first stage ST1 on which the excess portions 15a and 16a on the longer sides are removed by the trimming process, and the second stage ST2 on which the excess portions 15a and 16a on the shorter sides are removed by the trimming process, have substantially the same configuration and operation, except that their cutting directions are different from each other by 90°. Therefore, in FIG. 1, the trimming device 100 that performs the trimming process on the excess portions 15a and 16a of the longer sides on the first stage ST1 is shown, and the trimming device 100 that performs the trimming process on the excess portions 15a and 16a of the shorter sides on the second stage ST2 is not shown or described.

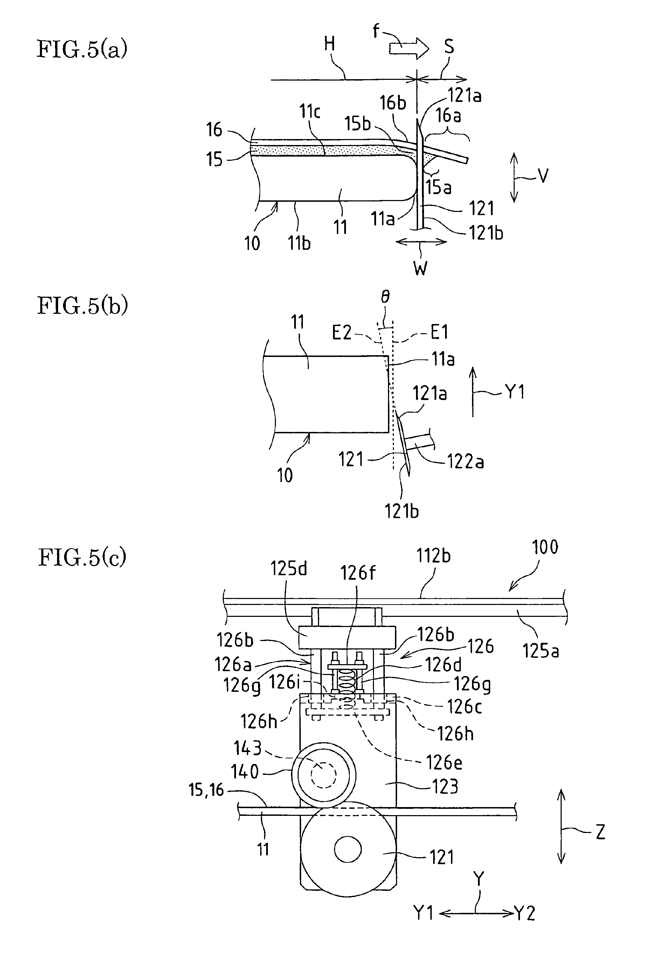

As shown in FIGS. 1-3, in a process of manufacturing the module 10 (here, a semiconductor module, such as a solar module) in which the quadrangular substrate 11 (here,a transparent insulating substrate, such as a transparent glass) on which a cell (here, a semiconductor cell, such as a solar cell) is mounted is sealed by an EVA 15 and a back sheet 16, the trimming device 100 removes the excess portions 15a and 16a (see FIG. 5 described below) of the EVA 15 and the back sheet 16 attached to the substrate 11, which protrude outward from an outer edge portion of the substrate 11, using rotating blades 121.

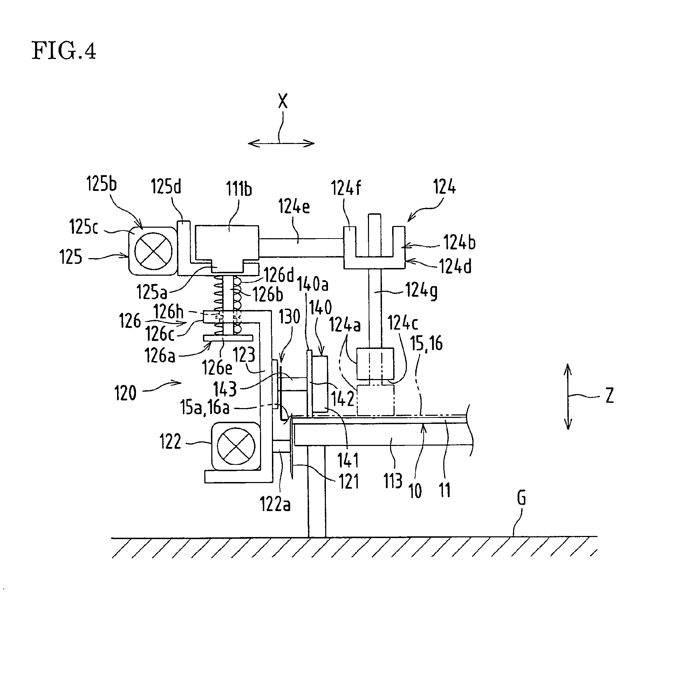

The trimming device 100 includes an elevating table 113 (see FIG. 4 described below) on which the module 10 is horizontally placed, a pair of first support portions 110a extending along the X direction, and a pair of second support portions 111b extending along the Y direction. The first support portions 110a are separated from each other by a spacing in the Y direction, and are fixed to a floor surface G (see FIG. 4) via supporting pillars (not shown) standing in a vertical direction. The second support portions 111b are separated from each other by a spacing in the X direction, and opposite end portions thereof in the Y direction are supported by the first support portions 110a and 110a.

The trimming device 100 includes a substrate positioning mechanism (not shown) and an excess portion cutting mechanism 120.

### (Substrate Positioning Mechanism)

The substrate positioning mechanism detects a contour of the substrate 11 as position information using an image capturing means, such as a CCD camera, and moves the module 10 in the X direction based on the detected position information. Note that the substrate positioning mechanism may move at least one of either the module 10 or the rotating blades 121 in the X direction.

### (Excess Portion Cutting Mechanism)

FIG. 4 is a cross-sectional view mainly showing the excess portion cutting mechanism 120, taken along line A-A of the trimming device 100 of FIG. 1. FIG. 5 is a diagram showing how the excess portions 15a and 16a are being cut by the rotating blade 121. FIG. 5(a) is a schematic cross-sectional view of the excess portions 15a and 16a. FIG. 5(b) is a schematic plan view of the excess portions 15a and 16a. FIG. 5(c) is a schematic side view of a portion including the rotating blades 121 and 121 of the trimming device 100 of FIG. 1, as viewed from the interior in a direction of a rotating shaft 122a. In FIG. 5(b), the EVA 15 and the back sheet 16 are not shown. Note that the excess portions 15a and 16a are cut in substantially the same manner on opposite sides of the substrate 11. Therefore, in FIGS. 4 and 5, one side of the substrate 11 is shown as a representative example, and the other side of the substrate 11 is not shown.
The same applies to the diagrams described below.

As shown in FIGS. 1, 4, and 5, the excess portion cutting mechanism 120 includes the rotating blades 121 and 121 provided on opposite sides in the X direction, rotation drive portions 122 and 122 that drive the respective rotating blades 121 and 121, rotating blade support portions 123 and 123 that support the respective rotating shafts 122a of the rotating blades 121 and 121 for rotation, holding portions 124 and 124 that hold the module 10 placed on the table 113, and cutting movement portions 125 and 125 that move the respective rotating blade support portions 123 and 123 in the cutting direction Y1.

The rotating blade 121, 121 has a circular shape as viewed in a direction of the rotating shaft 122a, 122a of the rotation drive portion 122, 122, and has a blade edge 121a (see FIG. 5) that has a sloped surface to become gradually sharper (i.e., narrower in a blade thickness direction (a W direction of FIG. 5(a)) outward along a radial direction (a V direction of FIG. 5(a)).

The rotation drive portion 122, 122 is a rotary motor that rotates the rotating blade 121, 121. The rotating shaft 122a, 122a and the rotating blade 121, 121 are coaxially connected together. The rotation drive portion 122, 122 can be switched between a forward rotation operation of rotating the rotating blade 121, 121 in one direction (the same direction as the cutting direction Y1) and a backward rotation operation of rotating the rotating blade 121, 121 in the other direction (a direction opposite to the cutting direction Y1).

The rotating blade support portion 123,123 supports the rotating shaft 122a of the rotating blade 121, 121 for rotation, in a closing direction with respect to the end face 11a of the substrate 11, with the blade edge 121a for cutting the excess portions 15a and 16a being inclined about an axis along the thickness direction (Z direction) of the substrate 11 at a cutting angle θ (see FIG. 5(b)) so that the blade edge 121a leans toward the substrate 11.
Here, the cutting angle θ is an angle between an imaginary plane E1 (see FIG. 5(b)) along the end face 11a of the substrate 11 and an imaginary plane E2 (see FIG. 5(b)) along a side face 121b perpendicular to the rotating shaft 122a of the rotating blade 121, as viewed in a direction perpendicular to a surface 11b and a rear face 11c of the substrate 11.

As shown in FIGS. 1 and 4, a plurality of the holding portions 124 and 124 are provided, extending along the Y direction (here, a pair of the holding portions 124 hold the module 10 on opposite sides in the Y direction). The holding portion 124, 124 includes clamp portions (substrate pressing portions) 124a and 124a that press the module 10 against the table 113, and pressing portion movement mechanisms 124b and 124b that move the clamp portions 124a and 124a back and forth in the Z direction.

The clamp portion 124a, 124a has a contact surface 124c, 124c that makes contact with the EVA 15 and the back sheet 16 of the module 10, whereby the module 10 can be reliably held on the contact surface 124c, 124c. The pressing portion movement mechanism 124b, 124b includes an actuator 124d, 124d that moves the clamp portion 124a, 124a back and forth in the Z direction. The actuator 124d, 124d includes a cylinder 124f, 124f supported by the second support portion 111b, 111b via a support member 124e, 124e, and a piston 124g, 124g that can be moved in the Z direction with respect to the cylinder 124f, 124f. The clamp portion 124a, 124a is provided at a tip portion of the piston 124g, 124g. In this embodiment, one clamp portion 124a (on the right side in FIG. 1) is integrally connected to one set of (here, a pair of) holding portions 124 (in the vertical direction in FIG. 1), while the other clamp portion 124a (on the left side in FIG. 1) is integrally connected to the other set of (here, a pair of) holding portions 124 (in the vertical direction in FIG. 1).

The cutting movement portion 125, 125 relatively moves at least one of either the rotating blade 121, 121 or the module 10 (here, the rotating blade 121, 121) in the cutting direction (here, the travel direction of the rotating blade 121, 121) Y1. The cutting movement portion 125, 125 includes a guide portion 125a, 125a that guides the rotating blade support portion 123, 123 along the Y direction, and a rotating blade cutting direction movement mechanism 125b, 125b that moves the rotating blade support portion 123, 123 back and forth in the Y direction. Here, the cutting movement portion 125, 125 moves the rotating blade 121, 121 at a first movement speed (low speed) (specifically, 70 mm/s) during the start of cutting and at a second movement speed (specifically, 221.7 mm/s) that is higher than the first movement speed after a predetermined time (e.g., one second) has elapsed (i.e., the movement speed is switched from the first one to the second one). Note that the tangential speed of the rotating blade 121, 121 is here 3.2 m/s.

Specifically, the guide portion 125a, 125a is provided on the second support portion 111b, 111b, and has a follower-type linear motion (LM) guide that freely moves to guide the rotating blade support portion 123, 123 in the Y direction with respect to the second support portion 111b, 111b. The rotating blade cutting direction movement mechanism 125b, 125b includes a travel drive portion 125c, 125c that moves the rotating blade support portion 123, 123 back and forth in the Y direction. The travel drive portion 125a, 125a causes a travel portion 125d, 125d including a wheel connected to a rotating shaft (not shown) to travel on the guide portion 125a, 125a, thereby moving the rotating blade support portion 123, 123 back and forth in the Y direction.

### (Trimming Step)

In the trimming device 100 described above, when the excess portions 15a and 16a of the module 10 are removed by the trimming process, as shown in FIG. 2 the module 10 is transported to the first stage ST1 on which the excess portions 15a and 16a on the longer sides of the substrate 11 of the module 10 are to be cut, and is placed on the table 113.

### [Module Positioning Step]

Next, the substrate positioning mechanism (not shown) is used to position the module 10. The pressing portion movement mechanism 124b is used to lower the clamp portions 124a and 124a, which in turn press the module 10, whereby the module 10 is held between the clamp portions 124a and 124a and the table 113 (see a dashed line in FIG. 4).

### [Excess Portion Cutting Step]

Thereafter, the rotating blade support portions 123 and 123 incline the rotating blades 121 and 121 about an axis along the Z direction toward the substrate 11 at the cutting angle θ (see FIG. 5(b)), and the cutting movement portions 125 and 125 relatively move at least one of either the rotating blades 121 and 121 or the module 10 (here, the rotating blades 121 and 121) along the cutting direction Y1 while the rotation drive portions 122 and 122 are rotating the rotating blades 121 and 121 in one direction, whereby the excess portions 15a and 16a on the longer sides of the substrate 11 are cut.

After the excess portions 15a and 16a have been cut off, the pressing portion movement mechanisms 124b and 124b move the clamp portions 124a and 124a up to release the module 10. As shown in FIG. 3, the module 10 is transported to the second stage ST2 on which the excess portions 15a and 16a on the shorter sides of the substrate 11 are to be cut.

Thereafter, similar to the first stage ST1, the module 10 transported to the second stage ST2 is held between the clamp portions 124a and 124a and the table 113. Thereafter, the rotating blade support portions 123 and 123 incline the rotating blades 121 and 121 about an axis along the Z direction toward the substrate 11 at the cutting angle θ, and the cutting movement portions 125 and 125 relatively move at least one of either the rotating blades 121 and 121 or the module 10 (here, the rotating blades 121) along the cutting direction X1 while the rotation drive portions 122 and 122 are rotating the rotating blades 121 and 121 in one direction, whereby the excess portions 15a and 16a on the shorter sides of the substrate 11 are cut.

In the conventional trimming process described in Patent Document 1, the cutter plate is vertically vibrated by ultrasound during the cutting of the excess portion, and therefore, shear stress is not uniform. Therefore, the cut surface is rough, and therefore, the residual amount is not stable. In contrast to this, in the trimming device 100 of this embodiment, the rotating blades 121 and 121 are rotated in one direction during the cutting of the excess portions 15a and 16a, resulting in uniform shear stress. Therefore, the roughness of the cut surface can be reduced, whereby the residual amount can be stabilized.

In addition, the rotating blade 121, 121 rotating in one direction is inclined about an axis along the Z direction toward the substrate 11 by the cutting angle θ, whereby wobbling in the rotating shaft direction of the rotating blade 121, 121 can be reduced, and therefore, the amount of the residual portions 15b and 16b can be proportionately stabilized.

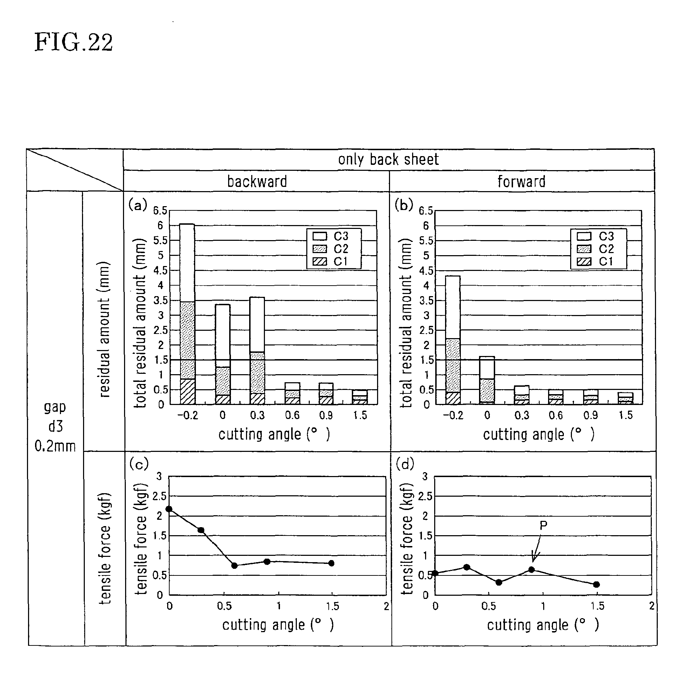

Specifically, as shown in FIG. 5(a), the EVA 15 and the back sheet 16 on the substrate 11 are fixed to the substrate 11 (see a region H in FIG. 5(a)), and the EVA 15 and the back sheet 16 outside the substrate 11 is free, i.e., is not fixed or held (see a region S in FIG. 5(a)). Therefore, the reaction forces on the rotating blade 121 from both sides in the blade thickness direction W are not equal to each other, and therefore, a force f acts on the rotating blade 121 in a direction away from the substrate 11. In particular, as the stiffness of the rotating blade 121 is decreased in order to reduce the cost, the rotating blade 121 is more likely to wobble due to the force f in the direction away from the substrate 11 when the rotating blade 121 is horizontal with respect to the end face 11a of the substrate 11. As a result, variations in the amount of the residual portions 15b and 16b increase proportionately, and moreover, the cut surface may be rough, i.e., have ridges and grooves. Therefore, in this embodiment, the rotating blade 121, 121 is previously inclined at the cutting angle θ in order to reduce the wobbling of the rotating blade 121, 121 that occurs due to the force f (see a correlation relationship between the cutting angle θ and the residual amount in example experiments of FIGS. 22 to 25 described below).

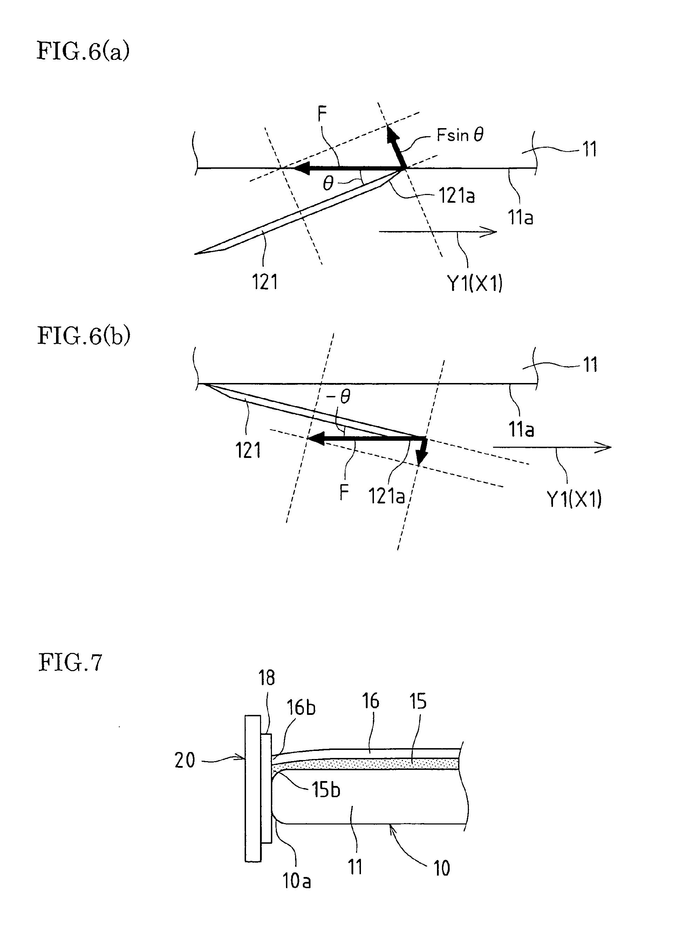

FIG. 6 is a diagram for describing a preferable value of the cutting angle θ of the rotating blade 121, 121. FIG. 6(a) shows a force acting on the rotating blade 121, 121 when the cutting angle θ of the rotating blade 121, 121 is excessively large. FIG. 6(b) shows a force acting on the rotating blade 121, 121 when the cutting angle θ of the rotating blade 121, 121 is excessively small.

As shown in FIG. 6(a), when the cutting angle θ of the rotating blade 121, 121 is excessively large (specifically, the cutting angle θ is larger than 10°), the rotating blade 121, 121 receives a resistance force F in the cutting direction (the Y1 direction (the X1 direction)). Therefore, as the cutting angle θ of the rotating blade 121, 121 increases, the rotating blade 121, 121 receives a proportionately larger force (Fsinθ) in a direction in which the rotating blade 121, 121 is bent. If the force (Fsinθ) is excessively large, the rotating blade 121, 121 is bent toward the substrate 11, so that the blade edge 121a, 121a wears rapidly, leading to a decrease in the life of the rotating blade 121, 121.

On the other hand, as shown in FIG. 6(b), when the cutting angle θ of the rotating blade 121, 121 is excessively small (specifically, the cutting angle θ is smaller than 0.6°), the blade edge 121a, 121a of the rotating blade 121, 121 is inclined in a direction in which the blade edge 121a, 121a is away from the end face 11a of the substrate 11 (in FIG. 6(b), the state of the rotating blade 121, 121 is emphasized) due to an influence (e.g., wobbling etc.) of the rotation of the rotating blade 121, 121. As a result, the force F acts on the rotating blade 121, 121 in a direction away from the end face 11a of the substrate 11, and therefore, the amount of the residual portions 15b and 16b increases, leading to a decrease in the stability of the residual amount.

Therefore, the lower limit value of the cutting angle θ is preferably about 0.6°. The upper limit value of the cutting angle θ is preferably about 10° because the rotating blade 121, 121 receives a component of the force F that is about 20% of the force F (sin10° (= 0.17)).

### [End Face Sealing Step]

Next, the end face 10a of the module 10 is sealed by the end-face sealing member 18 (end face sealing step) (see FIG. 39). This is similar to the step of FIG. 39. Therefore, here, the end face sealing step will not be described in detail.

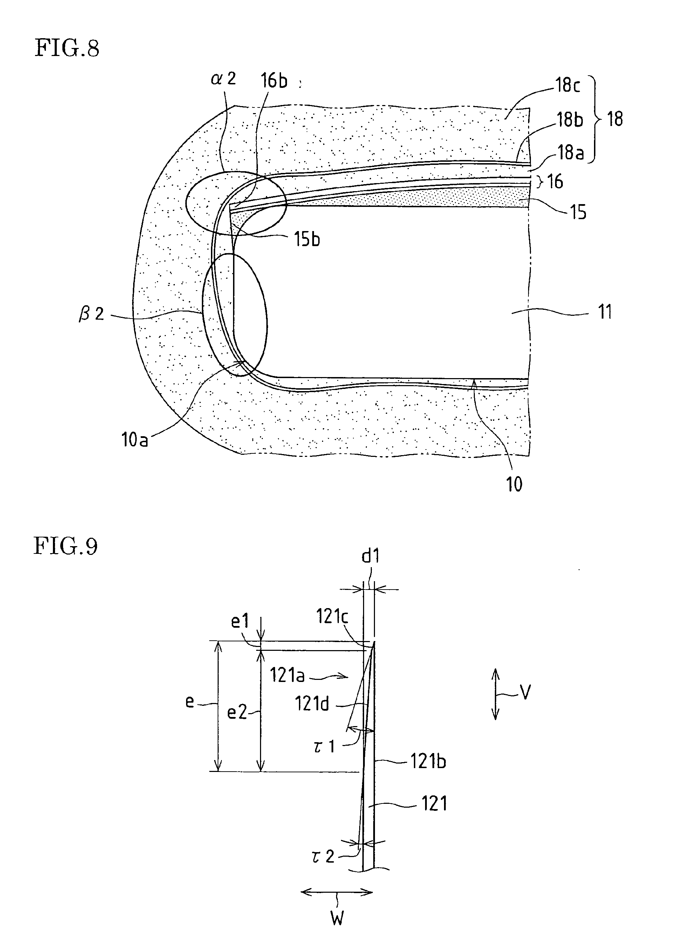

In the end face sealing step of FIG. 39, the residual amount of the excess portions 15a and 16a is stable in the excess portion cutting step in which the excess portions 15a and 16a have been cut, and therefore, the occurrence of defects due to variations in the residual amount, such as a defective attachment and a defective resistance to breakdown of the end-face sealing member 18, can be effectively prevented. This will be described in detail with reference to FIGS. 7 and 8.

FIG. 7 is a schematic cross-sectional view showing how the end face 10a of the module 10 is sealed by the end-face sealing member 18 in the end face sealing step. FIG. 8 is an enlarged cross-sectional view of the end face 10a of the module 10 sealed by the end-face sealing member 18 in the end face sealing step.

In the module 10, the EVA 15 (first sealing member) and the back sheet 16 (second sealing member) are successively formed on the substrate (specifically, a glass substrate) 11 in this stated order. The back sheet 16 includes two layers in this example. The end-face sealing member 18 includes three layers in this example, i.e., a butyl layer 18a, a polyethylene terephthalate (PET) layer 18b having a thickness of about 17 µm, and a foam layer 18c. The butyl layer 18a has an adhesive surface. This function allows the end-face sealing member 18 to be attached to the module 10. The butyl layer 18a has water vapor barrier properties and insulating properties, and protects the substrate 11. The foam layer 18c provides a cushion to allow the end-face sealing member 18 to make appropriate contact with the aluminum frame 19 that is to be fitted in a subsequent step.

The amount of the residual portions 15b and 16b in the trimming step is small (see α2 in FIG. 8) and stable (the residual amount is uniform over the entire end face 10a). Therefore, the end-face sealing member 18 held by a suction head (holding means) 20 (see FIG. 7) makes surface contact with the module 10 in the end face sealing step (see a portion β2 in FIG. 8), and therefore, the end-face sealing member 18 is stably attached to the end face 10a of the module 10. As a result, a defective attachment of the end-face sealing member 18 can be effectively prevented.

The end-face sealing member 18 also has a role in ensuring insulation from the module 10. Because the residual amount is small, the penetration of the residual portions 15b and 16b through the end-face sealing member 18 can be sufficiently reduced. As a result, a defective resistance to breakdown of the end-face sealing member 18 due to the residual portions 15b and 16b can be effectively prevented.

Moreover, in the trimming device 100, the blade edge 121a of the rotating blade 121 has a sloped surface to become gradually sharper (i.e., narrower in the blade thickness direction W) outward in the radial direction V Therefore, loading and a rough cut surface that would occur if a circular saw is used can be avoided.

In this embodiment, as shown in FIG. 9, the blade edge 121a of the rotating blade 121 has two different slope portions, i.e., a tip-side slope portion 121c having a blade edge angle τ1 and a rotation-center-side slope portion 121d having a tip anglo τ2 that is smaller than the blade edge angle τ1 of the tip-side slope portion 121c.

FIG. 9 is a side view schematically showing an example of the blade edge 121a of the rotating blade 121 having two different slope portions.

In the example of FIG. 9, the rotating blade 121 has a thickness d1 of 1.2 mm. The blade edge 121a has a length e of 15 mm in the radial direction V (the tip-side slope portion 121c has a length e1 of 1 mm, and the rotation-center-side slope portion 121d has a length e2 of 14 mm). The blade edge angle r1 of the tip-side slope portion 121c is 16.7°, and the tip angle τ2 of the rotation-center-side slope portion 121d is 3.678°.

Conventional knife-shaped cutter plates have a small effective length and therefore have a short life. In this embodiment, the rotating blade 121 is used as a cutting means, and therefore, the effective length is π (about 3.14) times the diameter. As a result, the cutting means can be used for a proportionately longer period of time, which it is difficult for conventional knife-shaped cutter plates to achieve.

Specifically, when the rotating blade 121 has a diameter of 150 mm, the effective cutter length is about 471 mm (≅ 150 mm × 3.14). This length cannot be achieved by conventional knife-shaped cutter plates (vertically vibrating cutters). Of course, a rotating blade having a diameter of more than 150 mm or less than 150 mm may be employed.

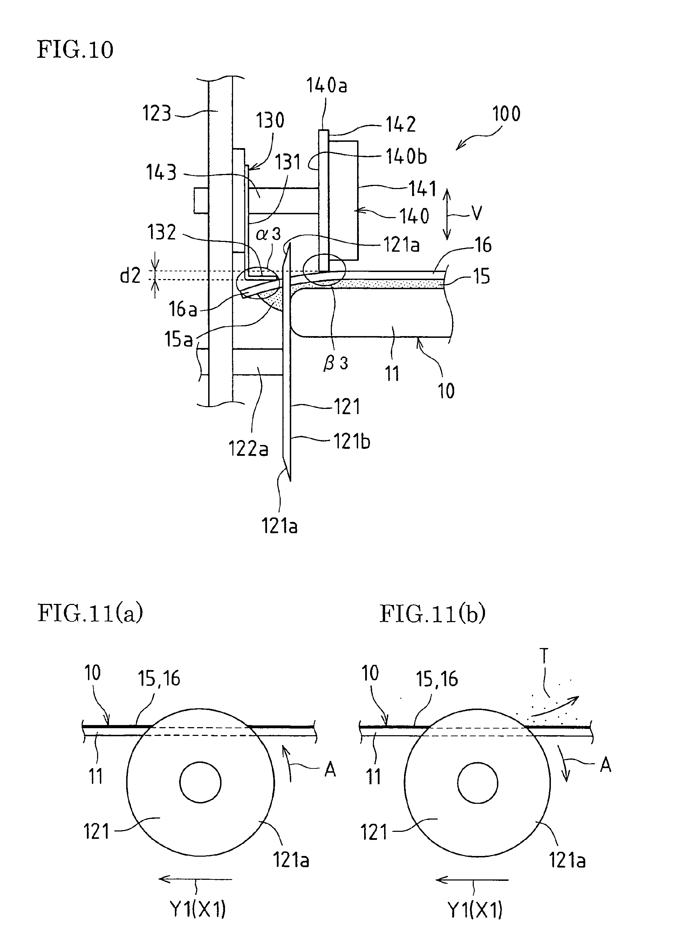

The rotating blade 121 is rotated in one direction A (see FIG. 11). Therefore, for example, a drive motor with low power consumption can be employed, whereby the cutting means can be driven at low output. Therefore, lower power consumption can be achieved and safety during maintenance can be ensured. While circular saws and dicing cutters are difficult to resharpen, in this embodiment the rotating blade 121 can be easily resharpened and used, and therefore, the running cost of the cutting means can be reduced (e.g., about one fifth of the price of a brand-new one).

When the trimming device 100 is mass-produced, there are various error factors, such as component tolerance, variations in the shape of the excess portions 15a and 16a, variations in the width of the excess portions 15a and 16a, warpage of the substrate (specifically, a glass substrate) 11, and variations in the temperature of the substrate 11. Therefore, a technique is required that accommodates these error factors and can be performed at low cost. This embodiment is advantageous over Patent Document 1 in terms of "low cost, "mass production," and "workability (safety)."

### (Uplift Restriction Member)

In this embodiment, the trimming device 100 includes an uplift restriction member 130 (here, a pair of restriction members 130 and 130 provided on opposite sides) that restricts uplift of the excess portions 15a and 16a cut by the rotating blade 121.

FIG. 10 is a side view schematically showing a portion of the excess portions 15a and 16a that is cut by the rotating blade 121 of the trimming device 100.

As shown in FIG. 10, the uplift restriction member 130 includes a plate-like restriction member body 131 supported by the rotating blade support portion 123, and a restriction portion 132 that is bent from a lower end portion of the restriction member body 131, extending toward the substrate 11, to face the excess portions 15a and 16a (specifically, bent at substantially right angles).

Thus, by providing the uplift restriction member 130 that restricts the uplift of the excess portions 15a and 16a cut by the rotating blade 121, the uplift (particularly, uplift on the upstream side in a rotation direction (a direction A) of a contact portion with the rotating blade 121) of the excess portions 15a and 16a caused by the shear stress of the rotating blade 121 can be restricted (see α3 in FIG. 10), and therefore, the excess portions 15a and 16a can be smoothly cut by the rotating blade 121.

### (Holding Roller)

In this embodiment, the trimming device 100 includes a holding roller 140 that holds the module 10 on one side (here, a side opposite to the rotating shaft 122a).

As shown in FIG. 10, the holding roller 140 is supported, for rotation, by a rotating shaft 143 supported by the rotating blade support portion 123. When the excess portions 15a and 16a of the module 10 are trimmed, the holding roller 140 is moved in the cutting direction (the Y1 direction (the X1 direction)) by the cutting movement portion 125 while being driven and rotated by an outer circumferential face 140a making contact with an upper face of the back sheet 16 in the module 10. Thus, the height positions of the holding roller 140 and the rotating blade 121 supported by the rotating blade support portion 123 can be specified by the outer circumferential face 140a of the holding roller 140 making contact with the module 10. Specifically, even if the module 10 has a non-uniform thickness or a slightly different height due to warpage of the substrate 11, variations in the thickness of the EVA 15, etc., the excess portions 15a and 16a can be stably cut while the position relationship between the rotating blade 121 and the substrate 11 in the Z direction is maintained constant. For example, when the module 10 has a non-uniform thickness, then if the holding roller 140 is not employed, the excess portions 15a and 16a are cut with non-uniform shear stress. In this case, by providing the holding roller 140, component tolerance can be accommodated, and therefore, the excess portions 15a and 16a can be cut with uniform shear stress.

Specifically, the holding roller 140 includes a roller portion 141, and a step-like portion 142 provided along the circumferential direction and protruding from the roller portion 141 outward in the radial direction V (e.g., protruding by about 0.5 mm). Thus, the holding roller 140 has the step-like portion 142, and therefore, the contact area between the outer circumferential face 140a and the module 10 can be reduced (see β3 in FIG. 10). As a result, the accuracy of the height position of the rotating blade 121 can be increased. The reduction of the contact area between the outer circumferential face 140a and the module 10 can lead to a reduction in chips that occur due to cutting of the excess portions 15a and 16a and adhere to the holding roller 140. Note that a distance (press height) d2 between the upper face (the outer circumferential face 140a of the holding roller 140) of the module 10 and the contact surface of the uplift restriction member 130 with respect to the excess portions 15a and 16a is here about -0.5 mm. Here, the value of the press height d2 of the uplift restriction member 130 is negative when the contact surface of the uplift restriction member 130 with respect to the excess portions 15a and 16a is lower than the upper face of the module 10. The same applies to the value of Example 4 described below.

### (Configuration in which the holding roller is not in contact with the rotating blade)

In this embodiment, when the excess portions 15a and 16a of the module 10 are trimmed, a side face 140b of the holding roller 140 that is closer to the rotating blade 121 perpendicular to the rotating shaft 122a of the rotating blade 121 is not in contact with the rotating blade 121.

Incidentally, if the side face 121b of the rotating blade 121 makes contact with the side face 140b of the holding roller 140, the side face 121b may wobble due to the rotation of the rotating blade 121, so that a load may be applied to the rotating blade 121, and therefore, the rotating blade 121 may be deformed. In this regard, in this embodiment, the side face 140b of the holding roller 140 is not in contact with the rotating blade 121, and therefore, there is not a load applied from the holding roller 140 to the rotating blade 121, and therefore, the deformation of the rotating blade 121 can be reduced. As a result, the amount of the residual portions 15b and 16b can be stabilized.

Also, because the side face 140b of the holding roller 140 is not in contact with the rotating blade 121, the direction (direction A) of rotation of the rotating blade 121 is not limited (see FIG. 11). Specifically, when the excess portions 15a and 16a are cut off, the rotating blade 121 may be rotated in the same direction (forward direction) as the cutting direction (the Y1 direction (the X1 direction)) or in a direction (backward direction) opposite to the cutting direction (the Y1 direction (the X1 direction)). Therefore, in this embodiment, when the excess portions 15a and 16a are cut off, the rotation drive portion 122 is configured to rotate the rotating blade 121 in the same direction (forward direction) as the cutting direction (the Y1 direction (the X1 direction)) or in the direction (backward direction) opposite to the cutting direction (the Y1 direction (the X1 direction)).

FIG. 11 is a schematic side view for describing the direction (direction A) of rotation of the rotating blade 121 with respect to the cutting direction (the Y1 direction (the X1 direction)). FIG. 11(a) shows how the rotating blade 121 is rotated in the same direction (forward direction) as the cutting direction (the Y1 direction (the X1 direction)), and FIG. 11(b) shows how the rotating blade 121 is rotated in the direction (backward direction) opposite to the cutting direction (the Y1 direction (the X1 direction)).

As shown in FIG. 11(a), when the direction (direction A) of rotation of the rotating blade 121 is forward, the cutting resistance of the rotating blade 121 can be reduced. As a result, the wear of the blade edge 121a of the rotating blade 121 can be reduced, and therefore, the cutting efficiency can be improved. The residual amount can also be more stabilized than when the direction (direction A) of rotation is backward. On the other hand, when the direction (direction A) of rotation of the rotating blade 121 is backward, chips T of the excess portions 15a and 16a are emitted in the direction opposite to the cutting direction (the Y1 direction (the X1 direction)). Therefore, the chips T less obstruct the cutting of the excess portions 15a and 16a performed by the rotating blade 121.

### (Thickness Direction Movement Portion)

In this embodiment, the trimming device 100 includes thickness direction movement portions 126 (FIGS. 4 and 5(c)) that relatively move at least one of either the rotating blades 121 or the module 10 (here, the rotating blades 121) along the Z direction.

As shown in FIGS. 4 and 5(c), the thickness direction movement portion 126 moves the rotating blade 121 back and forth in the Z direction. The thickness direction movement portion 126 includes a rotating blade height direction adjustment mechanism 126a that supports the rotating blade support portion 123 that supports the rotating shaft 122a of the rotating blade 121 for rotation, for adjustment of the rotating blade support portion 123 in the Z direction.

The rotating blade height direction adjustment mechanism 126a includes a pair of support bars 126b provided in the travel portion 125d along the Z direction, a movable portion 126c that is supported by the support bars 126b for movement in the Z direction and integrally connected to the rotating blade support portion 123, a helical member (e.g., a spring) 126d that is engaged with the movable portion 126c for sliding movement, and holding members 126e and 126f that hold the helical member 126d for rotation about an axis along the Z direction.

Specifically, the support bars 126b are aligned in the Y direction and stand in the Z direction on the lower face of the travel portion 125d. The holding members 126e and 126f hold the helical member 126d at opposite end portions thereof in the Z direction. The holding member 126e is supported by tips of the support bars 126b and 126b and holds one end portion of the helical member 126d. The holding member 126f is supported by a pair of support bars 126g and 126g standing on the upper face of the movable portion 126c in the Z direction for movement in the Z direction, and holds the other end portion of the helical member 126d. The movable portion 126c has through holes 126h in which the support bars 126b are inserted for sliding movement, and a through hole 126i in which the helical member 126d is inserted for sliding movement about an axis in the Z direction and engages with the helical member 126d.

The rotating blade height direction adjustment mechanism 126a rotates the helical member 126d about an axis along the Z direction to convert a rotational motion about the axis along the Z direction into a linear motion in the Z direction with respect to the movable portion 126c connected to the rotating blade support portion 123. As a result, the height of the rotating blade 121 supported by the rotating blade support portion 123 can be adjusted by the helical member 126d. In this embodiment, the movable portion 126c is formed of a metal plate in order to maintain the balance of the rotating blade 121.

When the height of the rotating blade 121 has been adjusted, the holding roller 140 supported by the rotating blade support portion 123 makes contact with the upper face of the module 10. Specifically, the height of the rotating blade 121 can be adjusted by changing the diameter of the holding roller 140, i.e., the rotating blade 121 does not need to be changed. Therefore, the holding roller 140 contributes to an improvement in the ease of the height adjustment. Thus, by setting the holding roller 140, depending on the height of the rotating blade 121, the rotating blade 121 can be easily adjusted to a height suitable for the module 10 to be trim.

In addition, by setting the center of rotation of the rotating blade 121 to be lower or higher than the module 10, the direction (direction A) of rotation of the rotating blade 121 can be easily set to be forward or backward.

### (Inclination Angle of Rotating Blade)

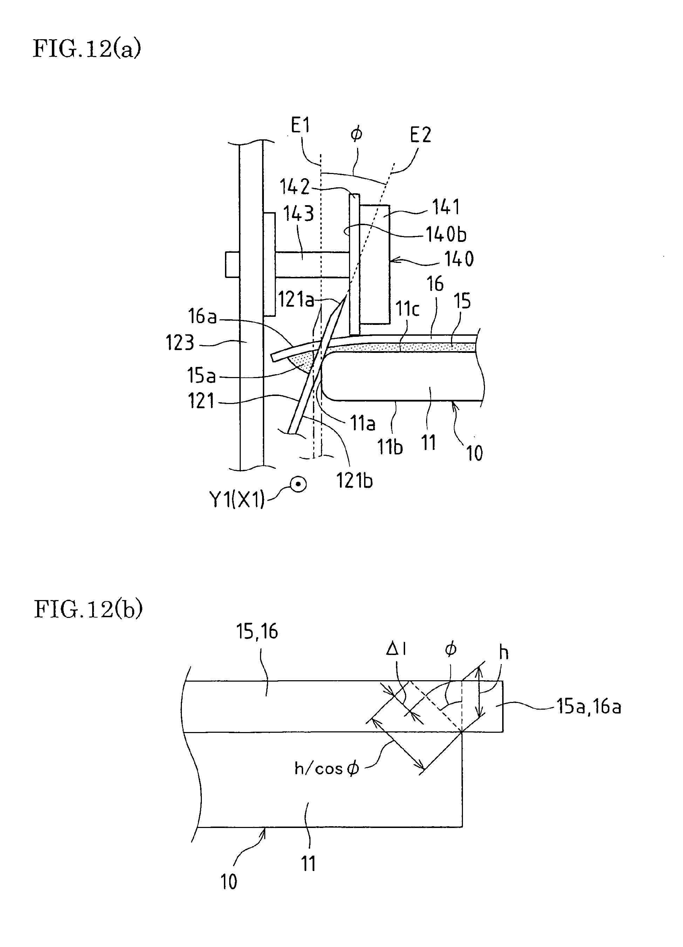

Because the side face 140b of the holding roller 140 is not in contact with the rotating blade 121, the rotating blade 121 may be inclined about an axis along the cutting direction (the Y1 direction (the X1 direction)) so that the blade edge 121a for cutting the excess portions 15a and 16a leans toward the substrate 11 (see FIG. 12).

FIG. 12 is a diagram for describing how the excess portions 15a and 16a are being cut by the rotating blade 121 that is inclined about the axis along the cutting direction (the Y1 direction (the X1 direction)) so that the blade edge 121a leans toward the substrate 11. FIG. 12(a) is a schematic side view of a portion including the rotating blade 121 of the trimming device 100. FIG. 12(b) is an enlarged side view of a cut portion of the excess portions 15a and 16a.

As shown in FIG. 12(a), the cutting movement portion 125 moves the rotating blade 121 along the cutting direction (the Y1 direction (the X1 direction)) while the rotating blade 121 is inclined about the axis along the cutting direction (the Y1 direction (the X1 direction)) toward the substrate 11 at an inclination angle φ. Here, the inclination angle φ is an angle between an imaginary plane E1 along the end face 11a of the substrate 11 and an imaginary plane E2 along the side face 121b perpendicular to the rotating shaft 122a of the rotating blade 121, as viewed in a direction parallel to the surface 11b and the rear face 11c of the substrate 11.

Thus, by inclining the rotating blade 121 about the axis along the cutting direction (the Y1 direction (the X1 direction)) toward the substrate 11, the excess portions 15a and 16a can be cut with high accuracy.

When the inclination angle φ = 0°, then if there is a resistance in the cutting direction (the Y1 direction (the X1 direction)), the rotating blade 121 is likely to be deformed outward, i.e., in a direction away from the substrate 11. If the rotating blade 121 is inclined about the axis along the cutting direction (the Y1 direction (the X1 direction)) toward the substrate 11 at the inclination angle φ, the resistance force applied from the front is distributed, whereby the rotating blade 121 can be prevented from being displaced away from the substrate 11. Therefore, if the inclination angle φ is negative, it is considerably difficult to cut the excess portions 15a and 16a, and in some cases, it is impossible to cut the excess portions 15a and 16a. Conversely, as shown in FIG. 12(b), as the inclination angle φ increases, a cutting length Δl increases by h/cosφ - h = h x (1 - cosφ)/cosφ, where h is the thickness of the excess portions 15a and 16a, and therefore, the life decreases proportionately.

Therefore, if the above trade-off is taken into consideration, the inclination angle φ is preferably more than 0° and less than or equal to 15° (the rate of the decrease in the life is less than 1%).

### (Rotating Shaft Cover)

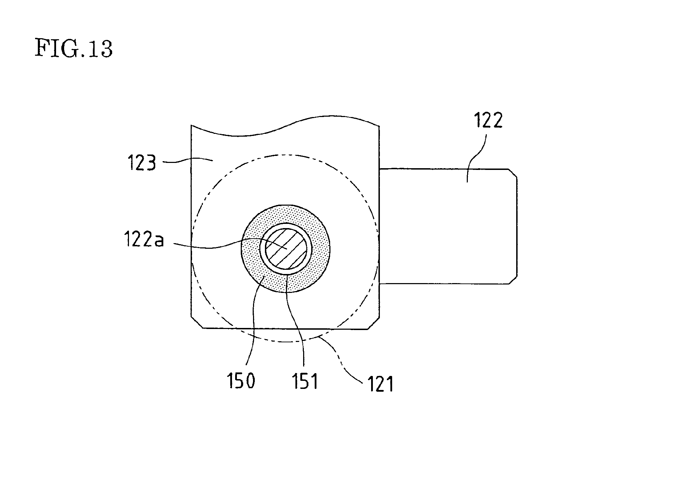

In this embodiment, the trimming device 100 may include a rotating shaft cover 150 that covers the rotating shaft 122a of the rotation drive portion 122 (see FIG. 13).

FIG. 13 is a side view schematically showing a portion including the rotating shaft 122a in a case where the rotating blade support portion 123 is provided with an example rotating shaft cover 150 for covering the rotating shaft 122a.

As shown in FIG. 13, the rotating shaft cover 150 has a donut shape. The rotating shaft cover 150 has, at a center portion thereof, a through hole 151 in which the rotating shaft 122a is inserted and allowed to rotate and that hides an outer circumferential face of the rotating shaft 122a. As a result, the outer circumferential face of the rotating shaft 122a of the rotation drive portion 122 is not exposed. Note that, in the trimming device 100 of this embodiment, the excess portions 15a and 16a fall by their weight after being cut, and are collected by a collection box (not shown) having a predetermined area.

With this configuration, the rotating shaft cover 150 prevents the outer circumferential face of the rotating shaft 122a of the rotation drive portion 122 from being exposed. As a result, the excess portions 15a and 16a can be prevented from being entangled with the rotating shaft 122a of the rotation drive portion 122, and therefore, can reliably fall into the collection box.

### (Adjustment of Gap between Rotating Blade and Substrate)

In this embodiment, in the trimming device 100, a gap between the rotating blade 121 and the substrate 11 may be adjustable.

Specifically, as shown in FIGS. 1 and 4, the gap between the rotating blade 121 and the substrate 11 can be adjusted by the substrate positioning mechanism (not shown).

Thus, the gap between the rotating blade 121 and the substrate 11 can be adjusted. Therefore, the gap between the rotating blade 121 and the substrate 11 can be adjusted, depending on various conditions, such as materials for the EVA 15 and the back sheet 16 or the angles θ and φ of the rotating blade 121.

### (Measures to Prevent Scattering of Chips)

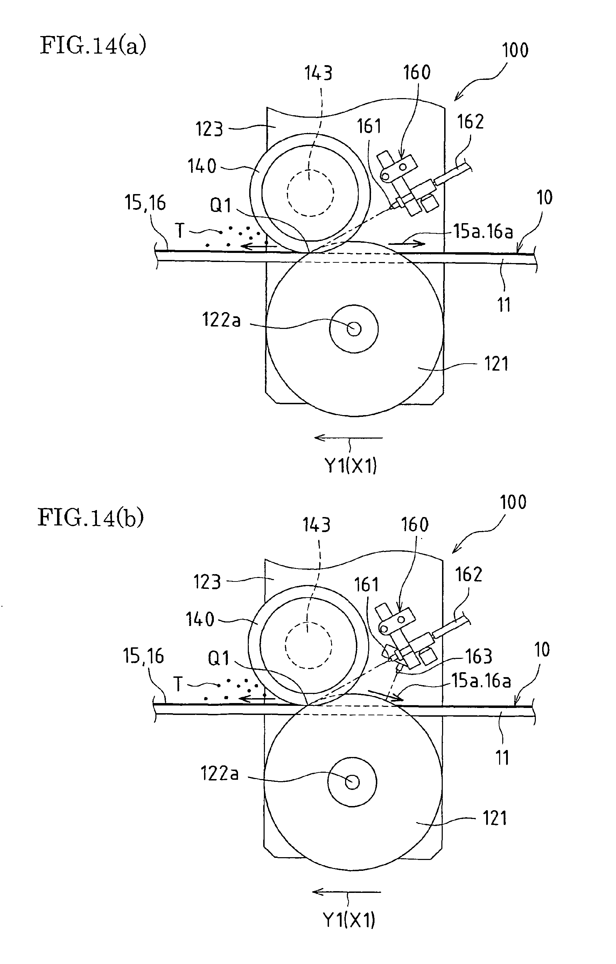

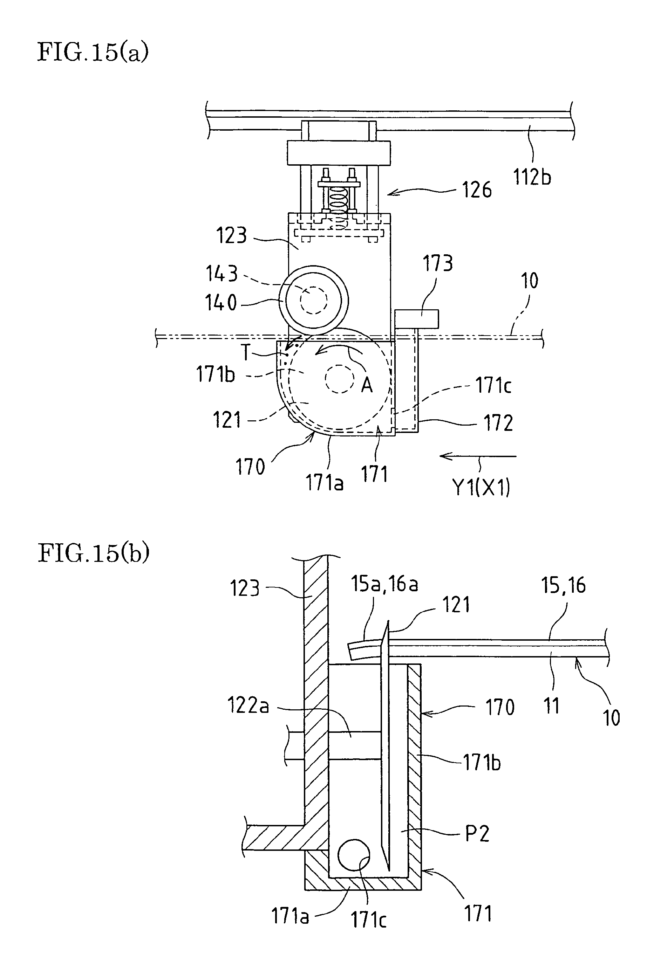

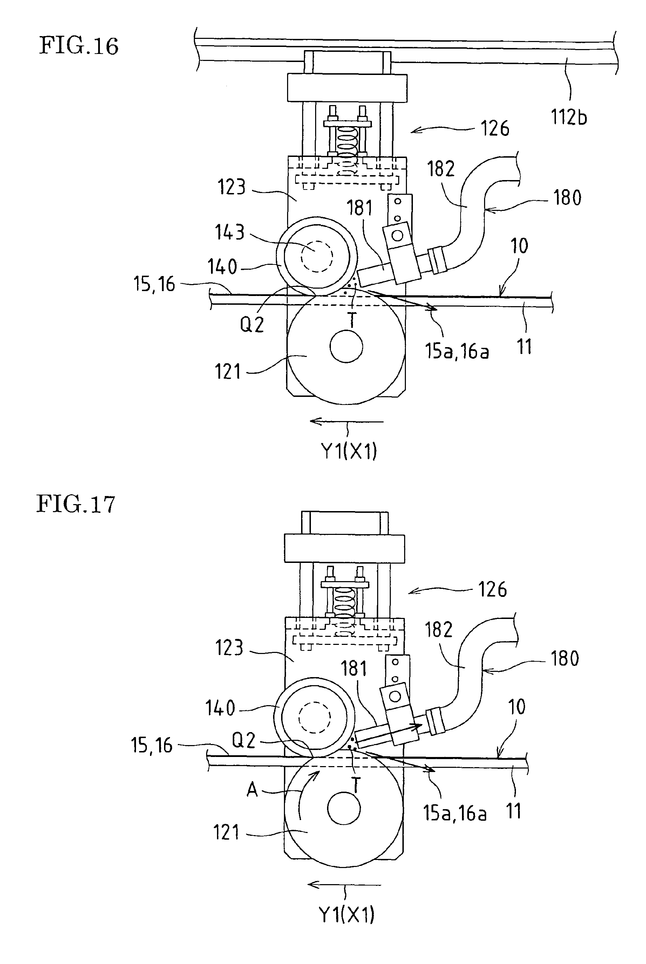

In this embodiment, as measures to prevent scattering of chips that occur during the cutting of the excess portions 15a and 16a by the rotating blade 121, at least one of an air blow device 160 (see FIG. 14), a first dust suction device 170 (see FIG. 15), and a second dust suction device 180 described below (see FIGS. 16 to 18) may be provided.

### (Air Blow Device)

FIG. 14 is a side view schematically showing the air blow device 160 provided in the trimming device 100. FIG. 14(a) shows an example of the air blow device 160, and FIG. 14(b) shows another example of the air blow device 160.

As shown in FIGS. 14(a) and 14(b), the air blow device 160 blows off the chips T of the excess portions 15a and 16a that have been cut off. The air blow device 160 includes an air blow nozzle 161 that ejects air, an air hose 162 that is in communication with the air blow nozzle 161, and an air compressor (not shown) that supplies air into the air hose 162. Specifically, the air blow nozzle 161 is oriented in an air eject direction toward a cutting point Q1 (target) that is somewhere in a contact portion of the rotating blade 121 and the excess portions 15a and 16a (here, a downstream end of the contact portion in the cutting direction (the Y1 direction (the X1 direction))) in order to blow off the chips T that occur immediately after the cutting.

With this configuration, the chips T that occur during the cutting of the excess portions 15a and 16a by the rotating blade 121 can be effectively blown off.

In addition, the air blow device 160 of FIG. 14(b) includes an air blow nozzle 163 for blowing off the excess portions 15a and 16a in addition to the air blow nozzle 161. Specifically, the air blow nozzle 163 is in communication with the air hose 162, and has an air eject direction toward the collection box (not shown) via a passage path after the cutting of the excess portions 15a and 16a in order to prevent scattering of fragments of the excess portions 15a and 16a. Thus, in addition to the function of blowing off the chips T by the air blow nozzle 161, the fragments of the excess portions 15a and 16a can be reliably caused to fall into the collection box.

Note that, in this embodiment, the air blow nozzles 161 and 163 are provided upstream from the cutting point Q1 in the cutting direction (the Y1 direction (the X1 direction)).

### (First Dust Suction Device)

FIG. 15 is a diagram schematically showing an example of the first dust suction device 170 of the trimming device 100. FIG. 15(a) is a side view thereof, and FIG. 15(b) is a cross-sectional view thereof.

As shown in FIG. 15, the first dust suction device 170, which sucks the chips T of the excess portions 15a and 16a that have been cut off, includes a dust suction pocket 171 that covers a portion of the rotating blade 121 that is lower than the module 10 to be cut by the rotating blade 121 and has a space P2 (see FIG. 15(b)) for accommodating the chips T that occur during the cutting of the excess portions 15a and 16a by the rotating blade 121, a dust suction hose 172 that is in communication with the dust suction pocket 171, and a dust suction machine 173 that sucks the chips T accommodated in the dust suction pocket 171 through the dust suction hose 172. Because the chips T also adhere around the rotating blade 121, the dust suction pocket 171 has a shape that can cover as large an area around the rotating blade 121 as possible. Specifically, the dust suction pocket 171 has a first pocket portion 171a that covers an outer circumferential portion of the rotating blade 121 along an outer circumferential direction of the rotating blade 121, and a second pocket portion 171b that covers the side face 121b along the side face 121b of the rotating blade 121. The first pocket portion 171a has a communication hole 171c that is in communication with the dust suction hose 172. One end of the dust suction hose 172 is connected to the communication hole 171c, and the other end is connected to the dust suction machine 173.

With this configuration, when the direction (direction A) of rotation of the rotating blade 121 is forward, the chips T occur in the front of the rotating blade 121 (downstream in the cutting direction (the Y1 direction (the X1 direction))) (see FIG. 15(a)). The entire dust suction pocket 171 serves as a suction inlet, and therefore, the chips T can be reliably sucked into the dust suction pocket 171, and then sucked through the dust suction hose 172 connected to the lower portion of the dust suction pocket 171 by the dust suction machine 173.

### (Second Dust Suction Device)

FIG. 16 is a side view schematically showing an example of the second dust suction device 180 of the trimming device 100.

As shown in FIG. 16, the second dust suction device 180, which sucks the chips T of the excess portions 15a and 16a that have been cut off, includes a dust suction nozzle 181 that sucks air, a dust suction hose 182 that is in communication with the dust suction nozzle 181, and a dust suction machine (not shown) that sucks the air from the dust suction nozzle 181 through the dust suction hose 182. Specifically, the dust suction nozzle 181 is oriented in a suction direction toward a cutting point Q2 (target) that is somewhere in the contact portion of the rotating blade 121 and the excess portions 15a and 16a (here, a downstream end of the contact portion in the cutting direction (the Y1 direction (the X1 direction))) in order to suction the chips T that occur immediately after the cutting.

When the trimming device 100 is mass-produced, the behavior of the excess portions 15a and 16a after being cut needs to be controlled. The excess portions 15a and 16a after being cut are present in the vicinity of the rotating blade 121, and therefore, move violently due to an influence of the rotation of the rotating blade 121. Therefore, if the excess portions 15a and 16a after being cut are caused to fall only by their weight, it is difficult to collect the excess portions 15a and 16a into the collection box having a limited area, and therefore, it is necessary to control the excess portions 15a and 16a somehow. It is difficult to provide a dust suction mechanism and an excess portion control mechanism at positions in the same direction. Therefore, it is more preferable that these mechanisms be provided in separate directions. Therefore, it is advantageous to set the direction (direction A) of rotation of the rotating blade 121 to be forward.

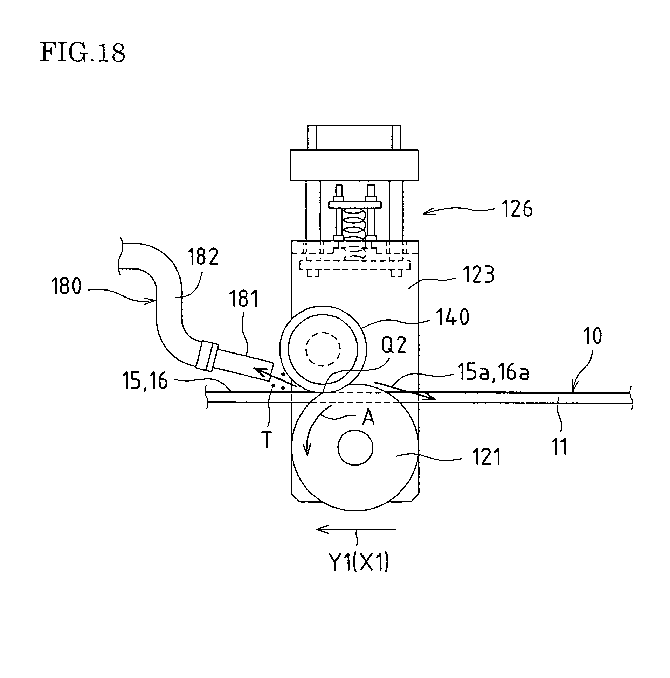

This will be described hereinafter with reference to FIGS. 17 and 18, based on the cases where the direction (direction A) of rotation of the rotating blade 121 is backward and forward, separately.

### (Backward Direction)

FIG. 17 is a schematic side view showing the chips T and the excess portions 15a and 16a after the cutting when the direction (direction A) of rotation of the rotating blade 121 is backward, in the trimming device 100 including the second dust suction device 180.

As shown in FIG. 17, when the direction (direction A) of rotation of the rotating blade 121 is backward, both the chips T and the excess portions 15a and 16a after being cut occur upstream (behind the rotating blade 121) in the cutting direction (the Y1 direction (the X1 direction)). Therefore, when the dust suction nozzle 181 is provided upstream from the cutting point Q2 in the cutting direction (the Y1 direction (the X1 direction)), the excess portions 15a and 16a after being cut as well as the chips T are sucked. Therefore, the excess portions 15a and 16a may get entangled in the suction inlet of the dust suction nozzle 181 or may be prevented from falling straight down. Therefore, a dust suction mechanism is required that does not have an influence on the behavior of the excess portions 15a and 16a, and therefore, a complicated design is required for mass production.

### (Forward Direction)

FIG. 18 is a schematic side view showing the chips T and the excess portions 15a and 16a after the cutting when the direction (direction A) of rotation of the rotating blade 121 is forward, in the trimming device 100 including the second dust suction device 180.

As shown in FIG. 18, when the direction (direction A) of rotation of the rotating blade 121 is forward, the chips T and the excess portions 15a and 16a after being cut occur in different directions, i.e., downstream and upstream in the cutting direction (the Y1 direction (the X1 direction)). Therefore, if the dust suction nozzle 181 is provided downstream from the cutting point Q2 in the cutting direction (the Y1 direction (the X1 direction)), the excess portions 15a and 16a can be caused to reliably fall straight down without getting entangled in the suction inlet of the dust suction nozzle 181. As a result, the dust suction mechanism can be placed without taking into consideration the behavior of the excess portions 15a and 16a.

Note that, in this embodiment, an air blow device that forces the excess portions 15a and 16a after being cut to fall straight down may be provided, or a chucking mechanism that performs a cutting operation while chucking and pulling the excess portions 15a and 16a after being cut off may be introduced.

### (About Examples)

### [1] Results of Preliminary Experiments

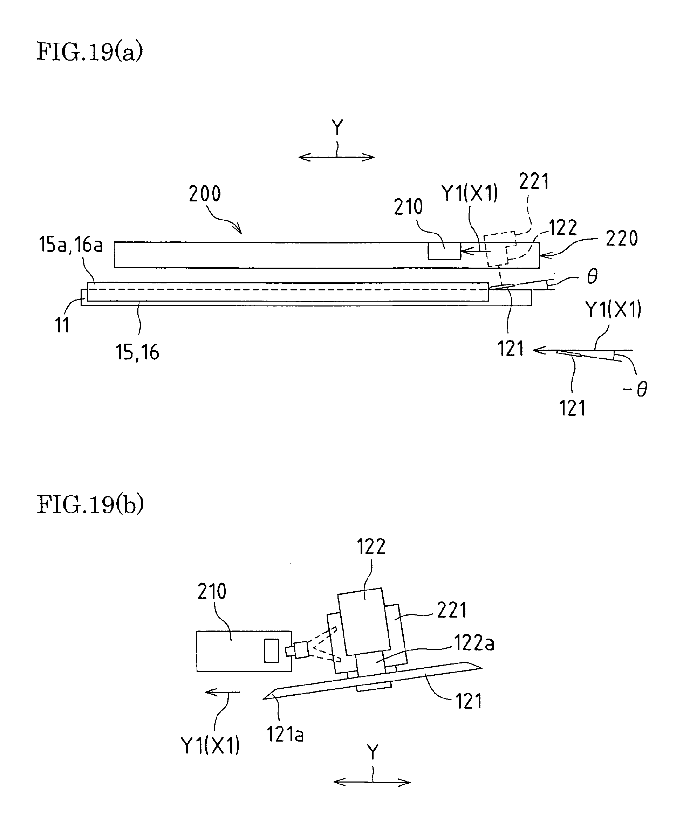

An experimental machine shown in FIG. 19 was produced in order to clarify optimum conditions for the cutting angle θ of the rotating blade 121.

FIG. 19 is a diagram showing the experimental machine 200 that was used to clarify the optimum conditions for the cutting angle θ of the rotating blade 121 during the cutting of the excess portions 15a and 16a. FIG. 19(a) is a schematic plan view of the experimental machine 200, and FIG. 19(b) is a schematic plan view of a portion including the rotating blade 121 of the experimental machine 200.

In the experimental machine 200, the rotation drive portion 122 that drives and rotates the rotating blade 121 is fixed to a movable portion 221 of an LM guide 220 that can move back and forth in the Y direction (with substantially no sliding resistance), and a tensile tester 210 (DFG-50T manufactured by SHIMPO) that can measure a cutting resistance (a tensile force in the cutting direction (the Y1 direction (the X1 direction)) of the rotating blade 121) is connected to the movable portion 221.

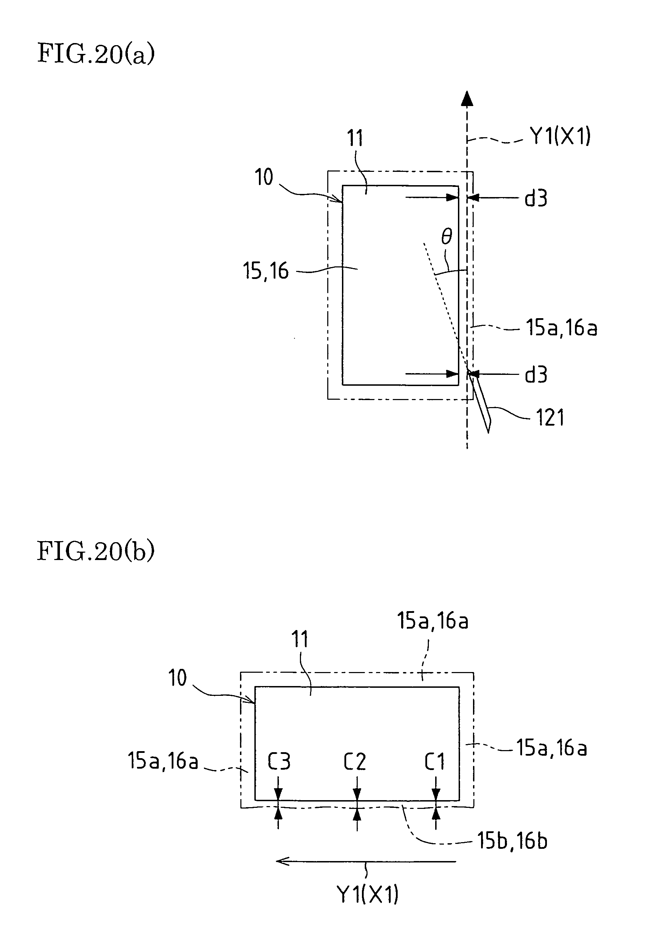

FIG. 20 is a plan view showing the excess portions 15a and 16a of the module 10 after being cut by the rotating blade 121 in the experimental machine 200 of FIG. 19. FIG. 20(a) shows the cutting angle θ of the rotating blade 121 and a gap d3 between the blade edge 121a of the rotating blade 121 and the substrate 11. FIG. 20(b) shows the amounts C1, C2, and C3 of the residual portions 15b and 16b after the cutting by the rotating blade 121. In FIG. 20(b), the residual amount C1 indicates a residual amount at a cutting start position in an upstream end portion in the cutting direction (the Y1 direction (the X1 direction)), the residual amount C2 indicates a residual amount at a cutting middle position in a middle portion in the cutting direction (the Y1 direction (the X1 direction)), and the residual amount C3 indicates a residual amount at a cutting end position in a downstream end portion in the cutting direction (the Y1 direction (the X1 direction)).

In this experiment, the residual amounts C1, C2, and C3 (see FIG. 20(b)) and the cutting resistance (the tensile force of the rotating blade 121 in the cutting direction (the Y1 direction (the X1 direction))) that were obtained when the cutting angle θ of the rotating blade 121 and the gap d3 between the blade edge 121a of the rotating blade 121 and the substrate 11 (see FIG. 20(a)) were changed, were measured once in each of the following cases: when the sealing member included only the back sheet 16; the sealing member included the EVA 15 and the back sheet 16; the direction (direction A) of rotation of the rotating blade 121 was backward; and the direction (direction A) of rotation of the rotating blade 121 was forward.

In the experiment, the rotating blade 121 (diameter: 150 mm) having the blade edge 121a of FIG. 9 was used. The tangential speed of the rotating blade 121 was 3.1 m/s (rotational speed: 400 rpm). The rotating blade 121 was manually moved. The rotating blade 121 was used to cut the excess portions 15a and 16a of the module 10 in which the substrate 11 having a thickness of 4.5 mm was sealed by the EVA 15 and the back sheet 16.

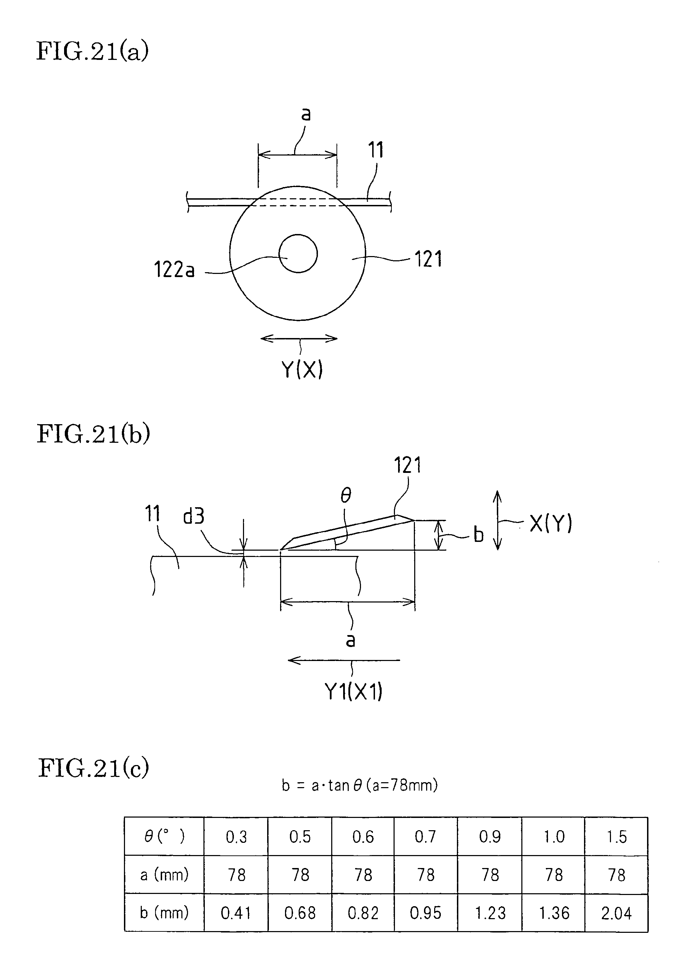

FIG. 21 is a diagram for describing facilitation of adjustment of the cutting angle θ. FIG. 21(a) is a side view showing a first distance a of a portion of the rotating blade 121 that overlaps the substrate 11 in the Y (X) direction, as viewed in a direction of the rotating shaft 122a. FIG. 21(b) is a plan view showing a second distance b between a downstream end portion and an upstream end portion in the cutting direction (the Y1 direction (the X1 direction)) of a portion of the rotating blade 121 that overlaps the substrate 11, in the X (Y) direction. FIG. 21(c) is a table showing values of the second distance b for obtaining the cutting angle θ. The second distance b can be calculated by [the first distance a] · tan([the cutting angle θ]). In this experiment, the first distance a was 78 mm.

As shown in FIG. 21(c), the cutting angle θ can be determined by setting the second distance b without measuring the cutting angle θ.

The results of the experiments are shown in FIGS. 22 to 25. FIG. 22 shows graphs indicating the residual amounts C1, C2, and C3 and the cutting resistance (the tensile force of the rotating blade 121 in the cutting direction (the Y1 direction (the X1 direction))), where the sealing member included only the back sheet 16, and the gap d3 between the blade edge 121a of the rotating blade 121 and the substrate 11 was 0.2 mm. FIGS. 22(a) and 22(b) show the residual amounts C1, C2, and C3 with respect to the cutting angle θ, where the direction (direction A) of rotation of the rotating blade 121 was backward and forward, respectively. FIGS. 22(c) and 22(d) show the tensile force with respect to the cutting angle θ, where the direction (direction A) of rotation of the rotating blade 121 was backward and forward, respectively.

FIG. 23 shows graphs indicating the residual amounts C1, C2, and C3 and the cutting resistance (the tensile force of the rotating blade 121 in the cutting direction (the Y1 direction (the X1 direction))), where the sealing member included only the back sheet 16, and the gap d3 between the blade edge 121a of the rotating blade 121 and the substrate 11 was 0.4 mm. FIGS. 23(a) and 23(b) show the residual amounts C1, C2, and C3 with respect to the cutting angle θ, where the direction (direction A) of rotation of the rotating blade 121 was backward and forward, respectively. FIGS. 23(c) and 23(d) show the tensile force with respect to the cutting angle θ, where the direction (direction A) of rotation of the rotating blade 121 was backward and forward, respectively.

FIG. 24 shows graphs indicating the residual amounts C1, C2, and C3 and the cutting resistance (the tensile force of the rotating blade 121 in the cutting direction (the Y1 direction (the X1 direction))), where the sealing member included the EVA 15 and the back sheet 16, and the gap d3 between the blade edge 121a of the rotating blade 121 and the substrate 11 was 0.2 mm. FIGS. 24(a) and 24(b) show the residual amounts C1, C2, and C3 with respect to the cutting angle θ, where the direction (direction A) of rotation of the rotating blade 121 was backward and forward, respectively. FIGS. 24(c) and 24(d) show the tensile force with respect to the cutting angle θ, where the direction (direction A) of rotation of the rotating blade 121 was backward and forward, respectively.

FIG. 25 shows graphs indicating the residual amounts C1, C2, and C3 and the cutting resistance (the tensile force of the rotating blade 121 in the cutting direction (the Y1 direction (the X1 direction))), where the sealing member included the EVA 15 and the back sheet 16, and the gap d3 between the blade edge 121a of the rotating blade 121 and the substrate 11 was 0.4 mm. FIGS. 25(a) and 25(b) show the residual amounts C1, C2, and C3 with respect to the cutting angle θ, where the direction (direction A) of rotation of the rotating blade 121 was backward and forward, respectively. FIGS. 25(c) and 25(d) show the tensile force with respect to the cutting angle θ, where the direction (direction A) of rotation of the rotating blade 121 was backward and forward, respectively.

As shown in FIGS. 22(a) to 25(a) and 22(b) to 25(b), the residual amounts C1, C2, and C3 tend to decrease with an increase in the cutting angle θ of the rotating blade 121.

As shown in FIGS. 22(c) to 25(c) and 22(d) to 25(d), when the direction (direction A) of rotation of the rotating blade 121 is backward, the cutting resistance mostly tends to increase (the tensile force tends to increase), compared to the forward direction.

When the direction (direction A) of rotation of the rotating blade 121 is backward, the cutting resistance (tensile force) tends to decrease with an increase in the cutting angle θ. On the other hand, when the direction (direction A) of rotation of the rotating blade 121 is forward, there is a point where the cutting resistance increases (see values at P in FIGS. 22(d) to 23(d)).

As shown in FIGS. 22(a) to 25(a) and 22(b) to 25(b), the smallest cutting angle θ that causes the total residual amount to be 1.5 mm or less, is 0.6°.

Incidentally, the end-face sealing member 18 is formed of three separate layers, i.e., the butyl layer 18a, the PET layer 18b, and the foam layer 18c, for the purpose of insulation. If the end-face sealing member 18 is broken by the residual portions 15b and 16b, a defective resistance to breakdown occurs. Therefore, as the reference, the residual amounts C1, C2, and C3 were each set to 0.5 mm or less, and in this example experiment, the total of the residual amounts C1, C2, and C3 was set to 1.5 mm or less.

In the case of such a criterion that the total of the residual amounts C1, C2, and C3 (three points) is 1.5 mm or less, not all points may have a residual amount of 0.5 or less. However, the rotating blade 121 receives a force in a direction away from the substrate 11, and therefore, it is inevitable that C1 ≤ C2 ≤ C3. Therefore, if any one of the residual amounts C1, C2, and C3 exceeds 0.5 mm, the total of the residual amounts C1, C2, and C3 inevitably exceeds 1.5 mm in almost all cases.

Therefore, when a minute change amount is not used in evaluation as in this experiment, the total residual amount of 1.5 mm or less may be used as a reference without a problem.

Also, as shown in FIGS. 22 to 25, the total of the residual amounts C1, C2, and C3 was smaller when the gap d3 between the blade edge 121a of the rotating blade 121 and the substrate 11 was 0.2 mm than when the gap d3 was 0.4 mm.

As can be seen from the foregoing description, the optimum conditions are that the direction (direction A) of rotation of the rotating blade 121 is backward, the cutting angle θ of the rotating blade 121 is 0.6°, and the gap d3 between the blade edge 121a of the rotating blade 121 and the substrate 11 is 0.2 mm.

### [2] Observation of End Face of Module and Side Face of Rotating Blade after Experiment

Next, after the experiment of the experimental example configuration, the end face 10a of the module 10 and a cross-section 121a of the rotating blade 121 were observed using magnified images thereof (not shown). As a result, no abnormality was found, and it was confirmed that the residual amounts C1, C2, and C3 can be stabilized by controlling the cutting angle θ.

### [3] Changes in Residual Amount

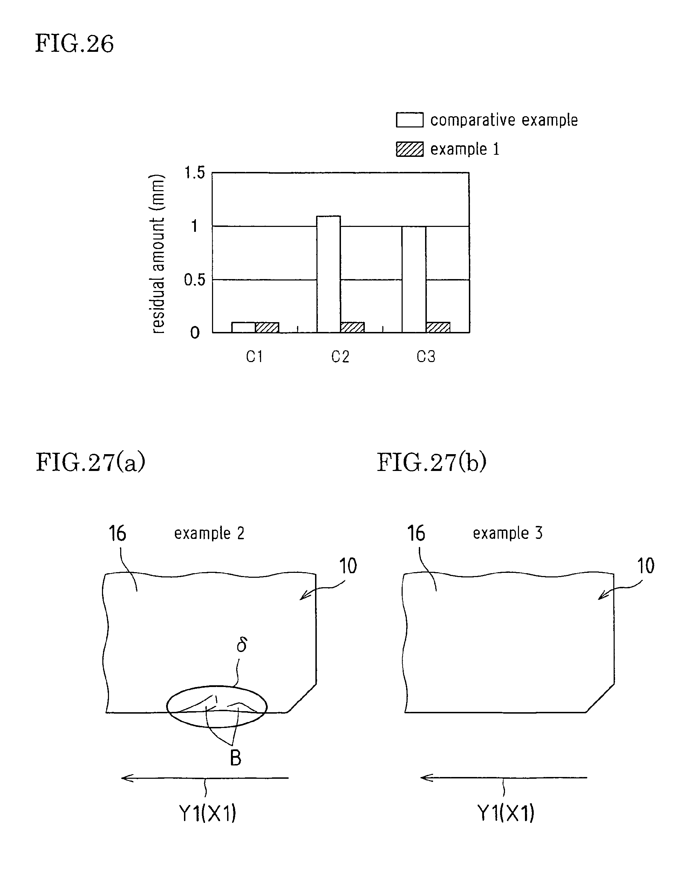

FIG. 26 is a graph showing the residual amounts C1, C2, and C3 of a comparative example and the residual amounts C1, C2, and C3 of Example 1.

In the comparative example, the direction (direction A) of rotation of the rotating blade 121 was forward, the cutting angle θ was 0°, and the gap d3 between the blade edge 121a of the rotating blade 121 and the substrate 11 was 0.2 mm. In Example 1, the direction (direction A) of rotation of the rotating blade 121 was backward, the cutting angle θ was 0.6°, and the gap d3 between the blade edge 121a of the rotating blade 121 and the substrate 11 was 0.2 mm.

When the excess portions 15a and 16a are cut along one side of the substrate 11, the number of times that the rotating blade 121 is used is incremented by one. In the comparative example, the residual amounts C1, C2, and C3 were measured after the rotating blade 121 had been used 8,928 times. In Example 1, the residual amounts C1, C2, and C3 were measured after the rotating blade 121 had been used 6,352 times. Here, the residual amounts C1, C2, and C3 may increase during an early period (about 1 to 3,000 times) of use of the rotating blade 121. Therefore, comparison was performed after the rotating blade 121 had been used a certain number of times (8,928 times in the comparative example and 6,352 times in Example 1) until the residual amounts C1, C2, and C3 were stabilized.

As shown in FIG. 26, in the comparative example, the residual amount C2 (a cutting middle position in a middle portion in the cutting direction (the Y1 direction (the X1 direction))) and the residual amount C3 (a cutting end position in a downstream end portion in the cutting direction (the Y1 direction (the X1 direction))) were large, and the residual amounts C1, C2, and C3 were not stable. In Example 1, the residual amounts C1, C2, and C3 were all small and stable. Thus, in Example 1, it was confirmed that the residual amounts C1, C2, and C3 can be reduced and the accuracy of the residual amounts C1, C2, and C3 can be improved.

### [4] Introduction of Uplift Restriction Member

Next, it was confirmed that the uplift restriction member 130 of FIG. 10 can be used to smoothly start the cutting of the excess portions 15a and 16a of the module 10.

FIG. 27 is an enlarged schematic plan view of a cutting start portion of the module 10 after the excess portions 15a and 16a of the module 10 had been cut. FIG. 27(a) shows Example 2 in which the uplift restriction member 130 was not provided, and FIG. 27(b) shows Example 3 in which the uplift restriction member 130 was provided.

In Examples 2 and 3, the direction (direction A) of rotation of the rotating blade 121 was backward, the cutting angle θ was 0.6°, and the gap d3 between the blade edge 121a of the rotating blade 121 and the substrate 11 was 0.2 mm.

In Example 2 in which the uplift restriction member 130 was not provided, as shown in FIG. 27(a), small burrs B occurred at an end portion of the back sheet 16 (see a portion δ). In Example 3, as shown in FIG. 27(b), the cutting was able to be achieved while burrs were sufficiently reduced at an end portion of the back sheet 16 due to the uplift restriction member 130.

In Example 2 in which the uplift restriction member 130 was not provided, the number of times that the rotating blade 121 was used was 2,600. In Example 3, due to the uplift restriction member 130, the uplift of the excess portions 15a and 16a that is caused by the shear stress of the rotating blade 121 was reduced, and therefore, the force applied to the rotating blade 121 was able to be stabilized, so that the number of times that the rotating blade 121 was used was as large as 10,000.

It was also confirmed that the cutting can be satisfactorily performed no matter whether the direction (direction A) of rotation of the rotating blade 121 is forward or backward. Specifically, it was found that the excess portions 15a and 16a (specifically, protruding amounts of the EVA 15 and the back sheet 16) can be stably cut if the excess portions 15a and 16a are 3 mm or more when the direction (direction A) of rotation of the rotating blade 121 is backward, and if the excess portions 15a and 16a are 1 mm or more when the direction (direction A) of rotation of the rotating blade 121 is forward.

Incidentally, if the distance (press height) d2 (see FIG. 10) between the upper face (the outer circumferential face 140a of the holding roller 140) of the module 10 and the contact surface of the uplift restriction member 130 with respect to the excess portions 15a and 16a is excessively large, the uplift restriction member 130 does not make contact with fragments of the excess portions 15a and 16a, and therefore, the cut surface is likely to be rough.

In this regard, the state of a cut surface obtained by the rotating blade 121 was studied by changing a protruding amount d5 (the excess portion 16a) of the back sheet 16 and the press height d2 of the uplift restriction member 130.

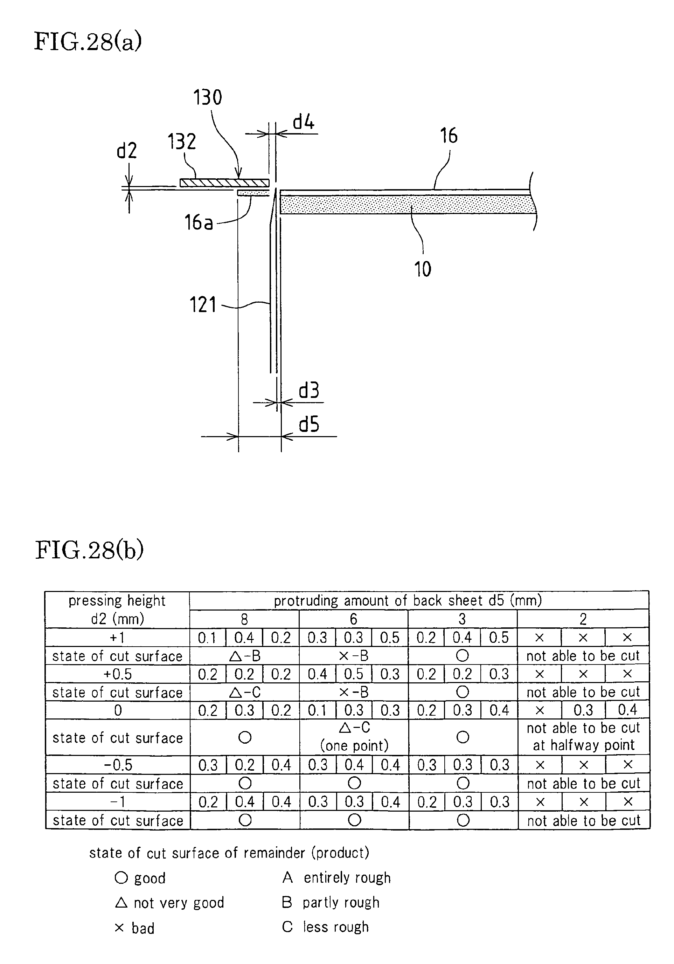

FIG. 28 is a diagram for describing Example 4 in which the state of a cut surface obtained by the rotating blade 121 was studied by changing the protruding amount d5 of the back sheet 16 and the press height d2 of the uplift restriction member 130. FIG. 28(a) is a diagram showing conditions for the experiment of Example 4, and FIG. 28(b) is a table showing the result of the experiment of Example 4.

In Example 4, the rotating blade 121 was rotated in a direction (backward direction) opposite to the cutting direction Y1. As shown in FIG. 28(a), a distance d4 between an end face closer to the module 10 of the rotating blade 121 and an end face closer to the rotating blade 121 of the uplift restriction member 130 was fixed to 1.5 mm. A distance d3 between the end face closer to the module 10 of the rotating blade 121 and an end face closer to the rotating blade 121 of the module 10 was fixed to 0.2 mm. The protruding amount d5 of the back sheet 16 was changed to 8 mm, 6 mm, 3 mm, and 2 mm, and the press height d2 of the uplift restriction member 130 was changed to 1 mm, 0.5 mm, 0 mm, -0.5 mm, and -1 mm.

In the table of FIG. 28(b), three numerical values shown for each value of the protruding amount d5 indicate the residual amounts C1, C2, and C3 of the residual portion 16b, respectively, from the left. For the module 10 whose excess portion 16a had been cut, the residual amounts C1, C2, and C3 were measured, and the outward appearance was evaluated (a good outward appearance is indicated by "○," a not very good appearance is indicated by "Δ," a bad outward appearance is indicated by "×," and the sample that was not able to be cut is indicated by "not able to be cut"). In the cases of the evaluations "Δ" and "×," the case where the entire residual portion 16b was rough (including ridges and grooves) is indicated by "A," the case where a part of the residual portion 16b was rough (including ridges and grooves) is indicated by "B," and the case where the proportion of a rough (including ridges and grooves) surface in the residual portion 16b was smaller than that of the state "B" of the cut surface is indicated by "C."

As can be seen from the experiment result of FIG. 28(b), the upper limit of the press height d2 is preferably about 0 mm.

On the other hand, if the press height d2 is excessively small (the contact surface of the uplift restriction member 130 with respect to the excess portions 15a and 16a is lower than the upper face of the module 10), the fragment of the excess portions 15a and 16a is excessively bent and therefore is likely to jump up due to vibration during the cutting. Therefore, the lower limit of the press height d2 is preferably about -1.0 mm. Thus, the press height d2 is preferably about -0.5 mm that is the middle value between the upper limit (about 0 mm) and the lower limit (about -1.0 mm).

### - Second Embodiment -

Next, a trimming method and a trimming device 100 according to a second embodiment will be described. According to the trimming method and the trimming device 100 of the second embodiment, similar to the trimming method and the trimming device 100 of the first embodiment, the residual amount of the excess portions 15a and 16a of the EVA 15 and the back sheet 16 in the module 10 in which the substrate 11 is sealed by the sealing member (the EVA 15 and the back sheet 16) can be stabilized. As a result, the occurrence of defects caused by variations in the residual amount, such as a defective attachment and a defective resistance to breakdown of the end-face sealing member 18, can be effectively prevented. Note that, in the trimming method and device of the second embodiment, components relating to the first embodiment are indicated by the same reference numerals.

The module trimming device 100 of this embodiment will be described hereinafter with reference to the drawings.

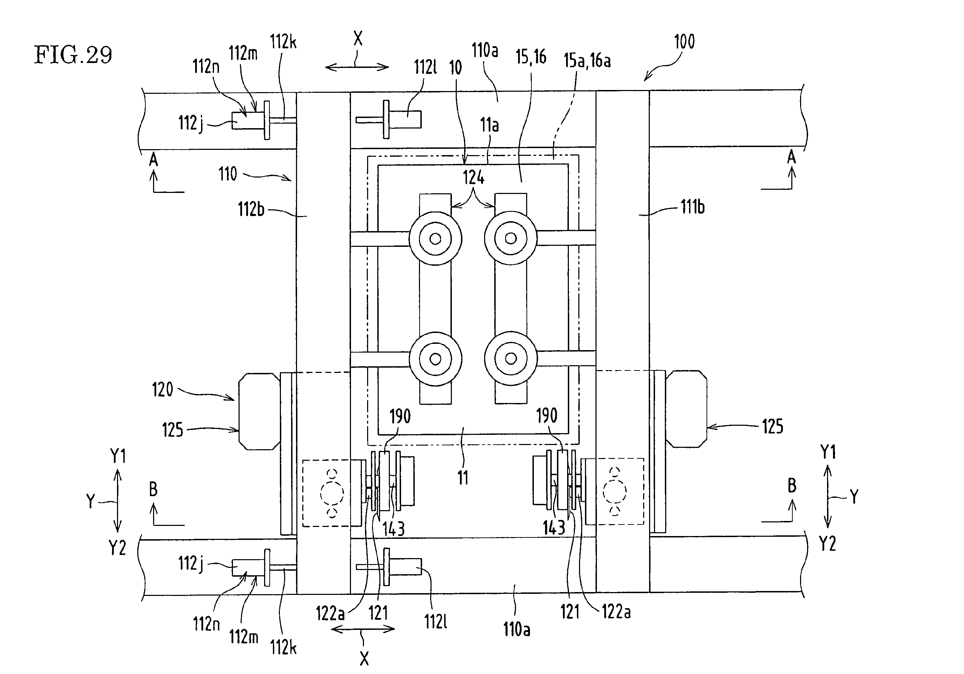

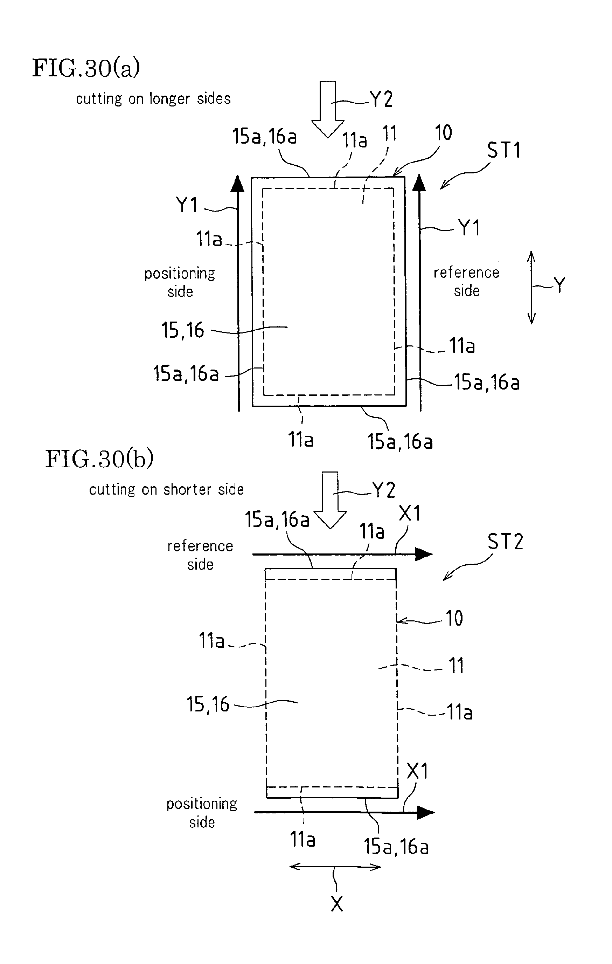

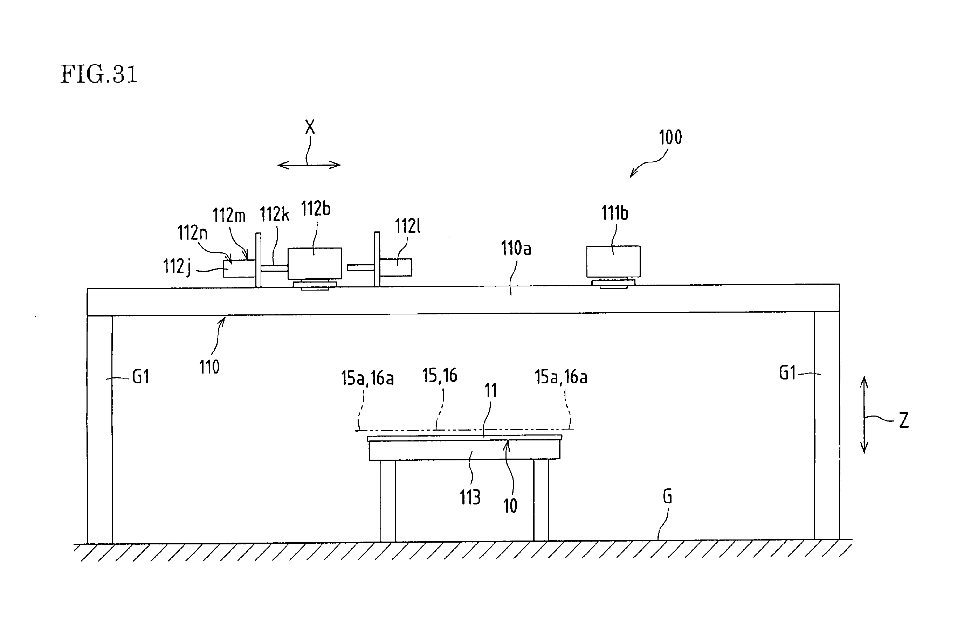

FIG. 29 is a plan view schematically showing a configuration of the trimming device 100 of this embodiment. FIG. 30 is a schematic plan view for describing a process of removing the excess portions 15a and 16a by the trimming process. FIG. 30(a) is a diagram for describing how the excess portions 15a and 16a on the longer sides are cut. FIG. 30(b) is a diagram for describing how the excess portions 15a and 16a on the shorter sides are cut. FIG. 31 is a cross-sectional view taken along arrows A-A of FIG. 29, mainly showing a cutting movement portion support mechanism 110. Note that the module 10 is similar to that of FIG. 37, and therefore, components are indicated by the same reference numerals as those of FIG. 37, and here, the module 10 will not be described in detail. FIG. 29 also shows the trimming device 100 on the first stage ST1 (see FIG. 30).

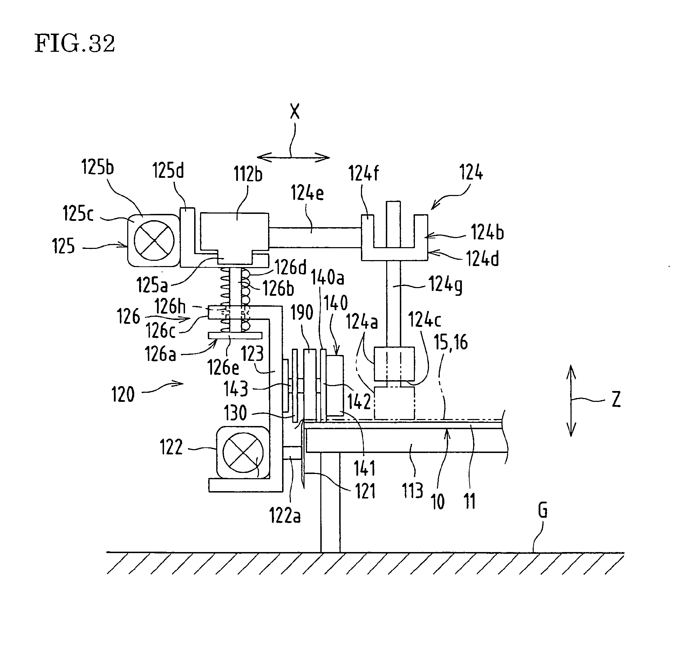

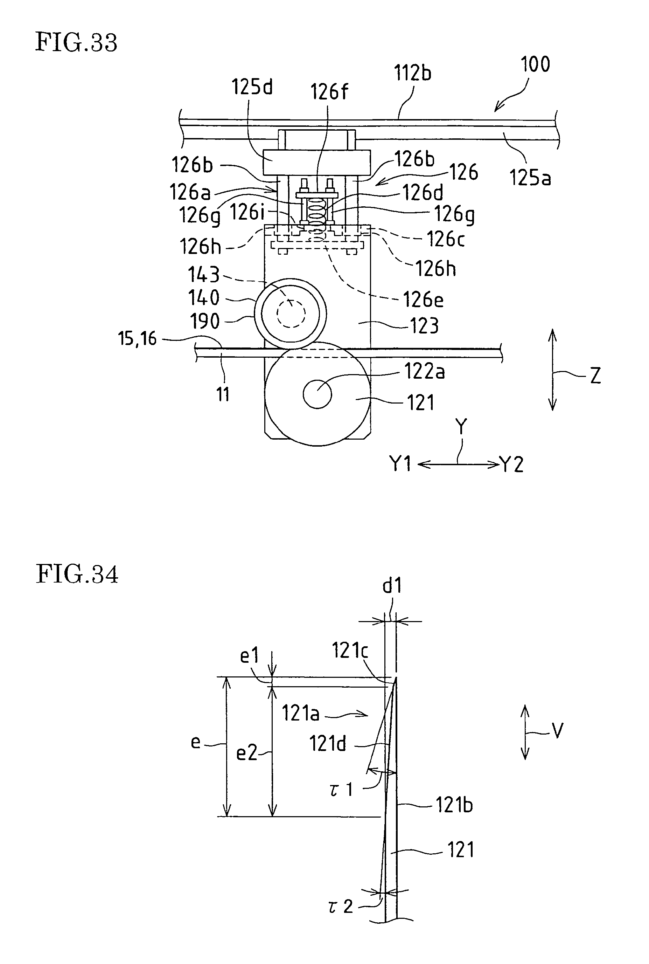

The trimming device 100 of this embodiment cuts off the excess portions 15a and 16a of the sealing members 15 and 16 of the module 10 in which the substrate 11 is sealed by the sealing members 15 and 16 (the EVA 15 and the back sheet 16). The trimming device 100 includes disk-shaped shear rollers 190 that press the module 10 from sides on which the sealing members 15 and 16 are provided, disk-shaped rotating blades 121 having a rotating shaft 122a parallel to a rotating shaft 143 of the shear roller 190 (the rotating shaft 143 of the holding roller 140) and a sharpened blade edge 121a (see FIG. 34) on an outer circumference thereof, rotation drive portions 122 (see FIG. 32) that drive the rotating blades 121 in one direction, and cutting movement portions 125 that relatively move at least one of either the rotating blades 121 or the module 10 in a cutting direction along the end face 11a of the substrate 11. The rotating blade 121 and the shear roller 190 are in contact with each other.

With this configuration, the resistance that occurs when the excess portions 15a and 16a are cut off can be reduced. As a result, even if the sealing members 15 and 16 have different thicknesses, the excess portions 15a and 16a can be cut off with high accuracy. Also, by providing the blade edge 121a along the entire circumference of the rotating blade 121, the length of the blade edge 121a can be increased to increase the life of the rotating blade 121.

The substrate 11 has a quadrangular shape. A direction parallel to the shorter sides of the substrate 11 is hereinafter referred to as an X direction, and a direction parallel to the longer sides of the substrate 11 is hereinafter referred to as a Y direction.

In this embodiment, after the excess portions 15a and 16a on the longer sides of the module 10 have been cut off on the first stage ST1 by the trimming device 100, the module 10 is transported to the second stage ST2, on which the excess portions 15a and 16a on the shorter sides are cut off by the trimming device 100. Note that the first stage ST1 and the second stage ST2 have substantially the same configuration and operation, except that their cutting directions are different from each other by 90°. The trimming device 100 on the second stage ST2 is not shown or described.

The trimming device 100 includes a substrate positioning mechanism (not shown), a cutting movement portion support mechanism 110, an excess portion cutting mechanism 120, and holding portions 124. The excess portion cutting mechanism 120 and the holding portions 124 will be described in detail below (see FIG. 32).

The substrate positioning mechanism detects a contour of the substrate 11 as position information using an image capturing means, such as a CCD camera, and moves the module 10 in the X direction based on the detected position information. Note that the substrate positioning mechanism may move at least one of either the module 10 or the rotating blades 121 in the X direction.

The trimming device 100 transports the module 10 in a transport direction (a Y2 direction) toward the first stage ST1, and lifts up the module 10 onto the first stage ST1. On the first stage ST1, two opposite sides (along the Y direction in FIG. 29, here the longer sides) of the substrate 11 in the module 10 are simultaneously cut in a cutting direction (a Y1 direction in FIG. 29) along end faces 11a and 11a of the substrate 11. Thereafter, the trimming device 100 transports the module 10 in the transport direction Y2 toward the second stage ST2, and lifts up the module 10 onto the second stage ST2. Thereafter, the other two opposite sides (along the X direction, here the shorter sides) are simultaneously cut in a cutting direction (an X1 direction) on the second stage ST2.

As shown in FIGS. 29 and 31, the cutting movement portion support mechanism 110 includes an elevating table 113 on which the module 10 is horizontally placed, a pair of first support portions 110a extending along the X direction, a second support portion 111b extending along the Y direction, a third support portion 112b extending along the Y direction, and a pair of support portion movement mechanisms 112m that move the third support portion 112b back and forth in the X direction.

The first support portions 110a are separated from each other by a spacing in the Y direction, and are fixed to a floor surface G via supporting pillars G1 and G1, respectively.

The second and third support portions 111b and 112b are separated from each other by a spacing in the X direction, and are supported by the first support portions.

The second support portion 111b is used as a reference support portion (on the right side in FIGS. 29 and 31). Opposite end portions in the Y direction of the second support portion 111b are fixed to the first support portions 110a and 110a.

The third support portion 112b is used as a pressing support portion (on the left side in FIGS. 29 and 31). Opposite end portions in the Y direction of the third support portion 112b are supported by the first support portions 110a and 110a for movement in the X direction.

The support portion movement mechanisms 112m are provided at the opposite end portions in the Y direction of the third support portion 112b, respectively. The support portion movement mechanism 112m includes an actuator 112n that moves the third support portion 112b back and forth in the X direction, and a stopper 1121 that restricts movement of the third support portion 112b toward the module 10 in the X direction.

The actuator 112n includes a cylinder 112j that is fixed to the first support portion 110a, and a piston 112k that can move from the cylinder 112j in the X direction.

The stopper 1121 is fixed to the first support portion 110a and is provided on the opposite side of the actuator 112n with respect to the third support portion 112b.

In this embodiment, the two pistons 112k are operated independently from each other. Specifically, the position in the X direction of the third support portion 112b is determined by the two pistons 112k and 112k that are provided and separated from each other by a spacing in the Y direction. Therefore, the third support portion 112b extending in the Y direction can be inclined in the X direction.

FIG. 32 is a cross-sectional view mainly showing the excess portion cutting mechanism 120, taken along arrows B-B of FIG. 29. FIG. 33 is a schematic side view of a portion including the rotating blades 121 and 121 of the trimming device 100 of FIG. 29, as viewed from the interior in a direction of the rotating shaft 122a. Note that the cut surface states of the excess portions 15a and 16a on the reference side and the pressing side are substantially the same. Therefore, in FIGS. 32 and 33, the pressing side is shown as a representative example, and the reference side is not shown.

As shown in FIGS. 32 and 33, the excess portion cutting mechanism 120 includes a rotating blade 121, a shear roller 190, a rotation drive portion 122, a rotating shaft support portion 123, and a cutting movement portion 125 on each of the reference and pressing sides. The holding portions 124 that hold the module 10 placed on the table 113 are further provided.

The holding portions 124 and 124 are provided on the reference and pressing sides, respectively. The holding portion 124 includes a clamp portion (substrate pressing portion) 124a that presses the module 10 against the table 113, and a pressing portion movement mechanism 124b that moves the clamp portion 124a back and forth in the Z direction. Note that, when the module 10 is held, the module 10 is pressed by the pair of clamp portions 124a and 124a provided on the reference and pressing sides.

The clamp portion 124a includes a contact surface 124c that makes contact with the EVA 15 and the back sheet 16 of the module 10 to reliably hold the module 10 on the contact surface 124c. The clamp portion 124a also extends in the Y direction.

The pressing portion movement mechanism 124b includes a pair of actuators 124d and 124d that are provided and separated from each other by a spacing in the Y direction. The actuators 124d move the clamp portion 124a back and forth in the Z direction.

The actuator 124d includes a cylinder 124f that is supported on the second support portion 111b or the third support portion 112b by the support member 124e, and a piston 124g that can move from the cylinder 124f in the Z direction. The clamp portion 124a is provided at a tip portion of the piston 124g.

The cutting movement portion 125 includes a guide portion 125a that guides the rotating shaft support portion 123 in the Y direction, and a rotating blade cutting direction movement mechanism 125b that moves the rotating shaft support portion 123 back and forth in the Y direction. In other words, in this embodiment, the cutting movement portion 125 moves the rotating blade 121 in the cutting direction Y1.

The guide portion 125a includes a follower-type linear motion (LM) guide that is provided in each of the second support portion 111b and the third support portion 112b, and guides the rotating shaft support portion 123 with respect to the second support portion 111b and the third support portion 112b for movement in the Y direction.

The rotating blade cutting direction movement mechanism 125b includes a travel drive portion 125c that moves the rotating shaft support portion 123 back and forth in the Y direction.

The travel drive portion 125c causes a travel portion 125d including a wheel connected to a rotating shaft (not shown) to travel on the guide portion 125a, thereby moving the rotating shaft support portion 123 back and forth in the Y direction.

The cutting movement portion 125 controls a relative movement speed between the rotating blade 121 and the module 10. With this configuration, the relative movement speed of the cutting movement portion 125 can be optimized for cutting off of the excess portions 15a and 16a. For example, if the relative movement speed is reduced to smoothly pull in the excess portions 15a and 16a during the start of the cutting off, defects such as burrs can be reduced.

Here, the movement speed of the rotating blade 121 during the start of the cutting is 70 mm/s, and the movement speed of the rotating blade 121 during the cutting is 151.6 mm/s. The cutting movement portions 125 on the reference and pressing sides are controlled for synchronization.

The rotating blade 121 has a circular shape as viewed in a direction of the rotating shaft 122a of the rotation drive portion 122, and has a sharpened blade edge 121a (see FIG. 34) along the outer circumference of the rotating blade 121.

The rotation drive portion 122 is a rotary motor that rotates the rotating blade 121 in one direction. The rotating shaft 122a and the rotating blade 121 are coaxially connected to the rotation drive portion 122.

The rotating shaft support portion 123 supports the rotating shaft 122a of the rotating blade 121 and the rotating shaft 143 of the shear roller 190. The rotating shaft support portion 123 allows a distance between the rotating shaft 122a of the rotating blade 121 and the rotating shaft 143 of the shear roller 190 to be constant. With this configuration, a contact angle between the rotating blade 121 and the shear roller 190 is caused to be constant, resulting in uniform shear stress.

Here, as shown in FIG. 33, part of the rotating blade 121 covers part of the shear roller 190, i.e., part of the rotating blade 121 does not cover part of the shear roller 190, as the rotating blade 121 is viewed in a direction of the rotating shaft 122a.

The shear roller 190 is supported by the rotating shaft support portion 123 for rotation. With this configuration, the rotational speed of the shear roller 190 can follow the rotational speed of the rotating blade 121, whereby the frictional resistance to the rotating blade 121 can be reduced, and therefore, the wear of the rotating blade 121 can be reduced.

As described above, the trimming device 100 includes the pair of rotating blades 121 and 121 that are used to simultaneously cut off the excess portions 15a and 16a on two opposite sides of the substrate 11. With this configuration, the excess portions 15a and 16a on two opposite sides of the substrate 11 can be simultaneously cut off, resulting in an improvement in processing speed.

The trimming device 100 includes a thickness direction movement portion 126 that is a suspending connector which is connected to the cutting movement portion 125 and from which the rotating shaft support portion 123 is suspended. The rotating shaft support portion 123 can rotate about an axis parallel to the thickness direction (the Z direction) of the substrate. With this configuration, the rotating blade 121 can be easily allowed to follow a distortion in the cutting direction along the end face of the substrate 11.
In other words, the rotating shaft support portion 123 can be rotated by inclining the third support portion 112b in the X direction.

The thickness direction movement portion 126 includes a rotating blade height direction adjustment mechanism 126a that is a support portion suspending mechanism that supports the rotating shaft support portion 123 for adjustment in the Z direction.

The rotating blade height direction adjustment mechanism 126a includes a pair of support bars 126b provided in the travel portion 125d along the Z direction, a movable portion 126c that is supported by the support bars 126b for movement in the Z direction and integrally connected to the rotating blade support portion 123, a helical member (e.g., a spring) 126d that is engaged with the movable portion 126c for sliding movement, and holding members 126e and 126f that hold the helical member 126d for rotation about an axis along the Z direction.

The support bars 126b are provided and aligned in the Y direction and stand in the Z direction on the lower face of the travel portion 125d.

The holding members 126e and 126f hold the helical member 126d at opposite end portions thereof in the Z direction.

The holding member 126e is supported by tips of the support bars 126b and holds one end portion of the helical member 126d.

The holding member 126f is supported by support bars 126g standing on the upper face of the movable portion 126c in the Z direction for movement in the Z direction, and holds the other end portion of the helical member 126d.

The movable portion 126c has through holes 126h in which the support bars 126b are inserted for sliding movement, and a through hole 126i in which the helical member 126d is inserted for sliding movement about an axis in the Z direction and engages with the helical member 126d.

The rotating blade height direction adjustment mechanism 126a rotates the helical member 126d about an axis along the Z direction to convert a rotational motion about the axis along the Z direction into a linear motion in the Z direction with respect to the movable portion 126c connected to the rotating blade support portion 123. As a result, the height of the rotating blade 121 supported by the rotating blade support portion 123 can be adjusted by the helical member 126d. In this embodiment, the movable portion 126c is formed of a metal plate in order to maintain the balance of the rotating blade 121.

FIG. 34 is a side view schematically showing an example of the blade edge 121a of the rotating blade 121 having two different slope portions.

The blade edge 121a of the rotating blade 121, which may be provided at an outer circumference of the the rotating blade 121, may have two different slope portions, i.e., a tip-side slope portion 121c having a blade edge angle τ1 and a rotation-center-side slope portion 121d having a tip angle τ2 that is smaller than the blade edge angle τ1 of the tip-side slope portion 121c.

In the example of FIG. 34, the rotating blade 121 has a thickness d1 of 1.2 mm. The blade edge 121a has a length e of 15 mm in a radial direction V (the tip-side slope portion 121c has a length e1 of 1 mm, and the rotation-center-side slope portion 121d has a length e2 of 14 mm). The blade edge angle τ1 of the tip-side slope portion 121c is 16.7°, and the tip anglo τ2 of the rotation-center-side slope portion 121d is 3.678°.

Specifically, when the rotating blade 121 has a diameter of 150 mm, the effective cutter length is about 471 mm (≅ 150 mm × 3.14). This length cannot be achieved by conventional knife-shaped cutter plates (vertically vibrating cutter). Of course, a rotating blade having a diameter of more than 150 mm or less than 150 mm may be employed.

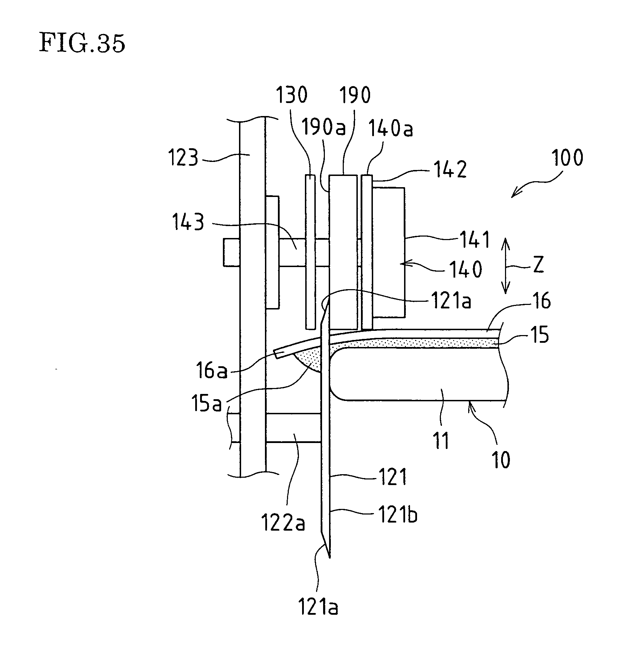

FIG. 35 is a side view schematically showing a portion of the excess portions 15a and 16a that is cut by the rotating blade 121 of the trimming device 100.

In this embodiment, the trimming device 100 includes an uplift restriction member 130 that restricts the uplift of the excess portions 15a and 16a.

With this configuration, the uplift of the excess portions 15a and 16a caused by the shear stress of the rotating blades 121 and 121 can be restricted, and therefore, the excess portions 15a and 16a can be smoothly cut by the rotating blades 121 and 121.

The uplift restriction member 130 is in the shape of a disk and is fixed to the rotating shaft 143 of the shear roller 190.

The trimming device 100 includes a holding roller 140 that is a following roller that follows the module 10. The rotating shaft support portion 123 supports the rotating shaft 143 of the holding roller 140. With this configuration, the holding roller 140 can be used to transfer a change (e.g., warpage) in a thickness direction (the Z direction) of the substrate 11 to the rotating shaft support portion 123. The cutting of the excess portions 15a and 16a can be stabilized by allowing the rotating blade 121 to follow the change of the rotating shaft support portion 123.

Note that, in this embodiment, the holding roller 140 is supported by the rotating shaft support portion 123 via the rotating shaft 143, for rotation, as with the shear roller 190.

When the excess portions 15a and 16a of the module 10 are cut in the trimming process, the holding roller 140 is moved in the cutting direction (the Y1 direction (the X1 direction)) by the cutting movement portion 125 while being driven and rotated by an outer circumferential face 140a thereof making contact with an upper face of the back sheet 16 in the module 10. Specifically, even if the module 10 has a non-uniform thickness or the module 10 has a slightly different height due to warpage of the substrate 11, variations in the thickness of the EVA 15, etc., the excess portions 15a and 16a can be stably cut while the position relationship between the rotating blade 121 and the substrate 11 in the Z direction is maintained constant. For example, when the module 10 has a non-uniform thickness, then if the holding roller 140 is not employed, the excess portions 15a and 16a are cut with non-uniform shear stress. In this case, by providing the holding roller 140, component tolerance can be accommodated, and therefore, the excess portions 15a and 16a can be cut with uniform shear stress.

Specifically, the holding roller 140 includes a roller portion 141, and a step-like portion 142 provided along the circumferential direction and protruding from the roller portion 141 in the Z direction (e.g., protruding by about 0.5 mm). Thus, the holding roller 140 has the step-like portion 142, and therefore, the contact area between the outer circumferential face 140a and the module 10 can be reduced. As a result, the accuracy of the height position of the rotating blade 121 can be increased.

The shear roller 190 is arranged so that a side face 190a thereof closer to the rotating blade 121 perpendicular to the rotating shaft direction makes contact with the side face 121b of the rotating blade 121. Also, the excess portions 15a and 16a are sandwiched by the rotating blade 121 and the shear roller 190 in the thickness direction (the Z direction) of the substrate.

In the trimming device 100 described above, when the excess portions 15a and 16a of the module 10 are cut in the trimming process, as shown in FIG. 30(a) the module 10 is transported to the first stage ST1 on which the excess portions 15a and 16a on the longer sides of the substrate 11 of the module 10 are to be removed by cutting, and is lifted up and then placed on the table 113.

Next, the substrate positioning mechanism (not shown) is used to position the module 10. The pressing portion movement mechanism 124b is used to lower the clamp portion 124a, which in turn presses the module 10, whereby the module 10 is held between the clamp portion 124a and the table 113 (see a dashed line in FIG. 32).

Thereafter, while the rotating blade 121 is being rotated in one direction by the rotation drive portion 122, at least one (here, the rotating blades 121) of the rotating blade 121 and the module 10 is relatively moved along the cutting direction Y1 by the cutting movement portion 125, and the excess portions 15a and 16a on the longer side of the substrate 11 are sandwiched and cut off by the rotating blade 121 and the shear roller 190.

After the excess portions 15a and 16a have been cut, the pressing portion movement mechanism 124b moves the clamp portion 124a up to release the module 10. As shown in FIG. 30(b), the module 10 is transported to the second stage ST2 on which the excess portions 15a and 16a on the shorter side of the substrate 11 are to be cut.

Thereafter, similar to the first stage ST1, the module 10 placed on the second stage ST2 is held between the clamp portion 124a and the table 113. Thereafter, the cutting movement portion 125 relatively moves at least one (here, the rotating blade 121) of the rotating blade 121 and the module 10 along the cutting direction X1 while the rotation drive portion 122 is rotating the rotating blade 121 in one direction, whereby the excess portions 15a and 16a on the shorter side of the substrate 11 are sandwiched and cut off by the rotating blade 121 and the shear roller 190.

Incidentally, there is a conventional trimming method relating to the second embodiment in addition to the trimming method of Patent Document 1, specifically, a technique of melt-cutting a substrate by moving a heated electric heating wire vertically at a constant speed (JP 2006-245265 A (hereinafter referred to as Patent Document 2)).

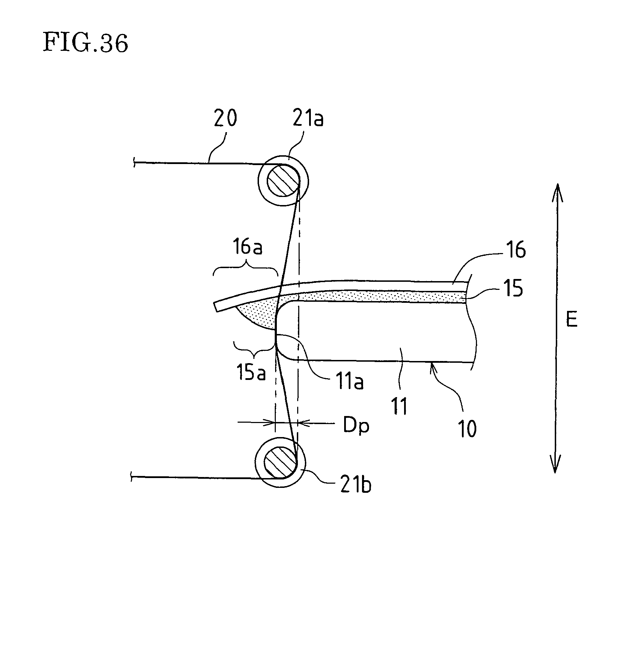

FIG. 36 is a diagram for describing a technique of cutting off an excess portion of a module using a heated electric heating wire.

A trimming device described in Patent Document 2 melt-cuts the excess portions 15a and 16a of the module 10 while moving a heated electric heating wire 20 in a vertical direction E at a constant speed. The electric heating wire 20 is linearly wound and hung around an upper guide roller 21a that is provided above the module 10 and a lower guide roller 21b that is provided below the module 10. The electric heating wire 20 is caused by a drive device (not shown) to endlessly travel between the upper guide roller 21a and the lower guide roller 21b at a constant speed. By moving the electric heating wire 20 along a perimeter of the module 10, the excess portions 15a and 16a are melt-cut. When the excess portions 15a and 16a are melt-cut, the electric heating wire 20 is pressed against the end face 11a of the substrate 11. In this case, the electric heating wire 20 is deformed by a displacement Dp compared to when the electric heating wire 20 is straight.

In the trimming device of Patent Document 2, in order to melt-cut the excess portion, it is necessary to heat the electric heating wire to high temperature, and therefore, the heated electric heating wire may be broken due to a rapid change in temperature. Materials that can be melt-cut are limited, depending on the temperature of the electric heating wire. Therefore, it is disadvantageously difficult to melt-cut the back sheet having a metal layer. Moreover, the displacement Dp of the electric heating wire 20 varies, depending on a force applied during melt-cutting, and therefore, burrs or the like may occur at an end face of a module.

In contrast to this, according to the trimming method of the second embodiment, the back sheet 16 is not melt-cut, and burrs or the like do not occur at the end face 10a of the module 10.

The present invention can be embodied and practiced in other different forms without departing from the spirit and essential characteristics thereof. Therefore, the above-described embodiments are considered in all respects as illustrative and not restrictive. The scope of the invention is indicated by the appended claims rather than by the foregoing description. All variations and modifications being within the equivalency range of the appended claims are intended to be embraced therein.

This application claims priority on Patent Application No. 2010-133912 filed in Japan on June 11, 2010 and Patent Application No. 2010-138625 filed in Japan on June 17, 2010, which are hereby incorporated by reference in their entirety.

### Description of Reference Numerals

- 10: MODULE
- 11: SUBSTRATE
- 11a: END FACE
- 15: EVA (EXAMPLE SEALING MEMBER)
- 15a: EXCESS PORTION
- 16: BACK SHEET (EXAMPLE SEALING MEMBER)
- 16a: EXCESS PORTION
- 100: TRIMMING DEVICE
- 121: ROTATING BLADE
- 121a: BLADE EDGE
- 122: ROTATION DRIVE PORTION
- 123: ROTATING BLADE SUPPORT PORTION
- 125: CUTTING MOVEMENT PORTION
- 126: THICKNESS DIRECTION MOVEMENT PORTION
- 130: UPLIFT RESTRICTION MEMBER
- 140: HOLDING ROLLER
- 150: ROTATING SHAFT COVER
- 160: AIR BLOW DEVICE
- 170: FIRST DUST SUCTION DEVICE
- 180: SECOND DUST SUCTION DEVICE
- d3: GAP
- A: DIRECTION OF ROTATION
- V: RADIAL DIRECTION
- W: BLADE THICKNESS DIRECTION
- X1: CUTTING DIRECTION
- Y1: CUTTING DIRECTION
- Z: THICKNESS DIRECTION
- θ: CUTTING ANGLE
- τ2: TIP ANGLE
- φ: INCLINATION ANGLE

## Claims

1. A trimming method for removing an excess portion of a sealing member that seals a substrate of a module, wherein
a rotating blade having a blade edge that has a sloped surface to become gradually narrower in a blade thickness direction outward along a radial direction is inclined about an axis along a thickness direction of the substrate toward the substrate at a cutting angle, and the excess portion is cut off by relatively moving at least one of the rotating blade and the module in a cutting direction along an end face of the substrate while the rotating blade is being rotated in one direction.

2. A trimming device for removing an excess portion of a sealing member that seals a substrate of a module, comprising:
a rotating blade having a sloped surface to become gradually narrower in a blade thickness direction outward along a radial direction;
a rotating blade support portion that supports the rotating blade with the rotating blade being inclined about an axis along a thickness direction of the substrate toward the substrate at a cutting angle;
a rotation drive portion that rotates the rotating blade in one direction; and
a cutting movement portion relatively moves at least one of the rotating blade and the module in a cutting direction along an end face of the substrate.

3. The trimming device according to claim 2, wherein
the cutting angle of the rotating blade is within the range of 0.6° to 10°.

4. The trimming device according to claim 2 or 3, wherein
the rotating blade has a tangential speed being within the range of 2.0 m/s to 5.5 m/s.

5. The trimming device according to any one of claims 2 to 4, wherein
a relative movement speed between the rotating blade and the module is the range of 233.3 mm/s or less.

6. The trimming device according to any one of claims 2 to 5, comprising:
an uplift restriction member that restricts uplift of the excess portion cut off by the rotating blade.

7. The trimming device according to any one of claims 2 to 6, wherein the blade edge has a tip angle being within the range of 10° to 30°.

8. The trimming device according to any one of claims 2 to 7, comprising:
a holding roller that holds the module on one surface thereof without being in contact with the rotating blade.

9. The trimming device according to claim 8, wherein
the holding roller has a roller portion, and a step-like portion provided along a circumferential direction and protruding from the roller portion outward in the radial direction.

10. The trimming device according to any one of claims 2 to 9, wherein
the rotation drive portion rotates the rotating blade in the same direction as the cutting direction or in a direction opposite to the cutting direction.

11. The trimming device according to any one of claims 2 to 10, comprising:
a thickness direction movement portion relatively moves at least one of the rotating blade and the module in the thickness direction of the substrate.

12. The trimming device according to any one of claims 2 to 11, wherein
the cutting movement portion relatively moves at least one of the rotating blade and the module in the cutting direction with the rotating blade being inclined about an axis along the cutting direction toward the substrate at an inclination angle.

13. The trimming device according to any one of claims 2 to 12, comprising:
a pair of the rotating blades so that excess portions on two opposite sides of the substrate are simultaneously cut off.

14. The trimming device according to claim 12, wherein
the inclination angle of the rotating blade is within the range of 0° or more and 15° or less.

15. The trimming device according to any one of claims 2 to 14, comprising:
a rotating shaft cover that covers a rotating shaft of the rotation drive portion.

16. The trimming device according to any one of claims 2 to 15, comprising:
an air blow device blows off chips of the excess portion that has been cut off.

17. The trimming device according to any one of claims 2 to 16, comprising:
a dust suction device suctions chips of the excess portion that has been cut off.
